# EUROPÄISCHE PATENTSCHRIFT

(11) **EP 2 565 591 B1**
(45) Veröffentlichungstag und Bekanntmachung des Hinweises auf die Patenterteilung: **18.06.2014**
(21) Anmeldenummer: 11179193.5
(22) Anmeldetag: 29.08.2011
(51) Int. Cl.: G01D 11/24, H03K 17/96

(54) **Grundkörper für kapazitiven Schalter**
Base body for capacitative switch
Corps de base pour commutateur capacitif

(43) Veröffentlichungstag der Anmeldung: 06.03.2013
(73) Patentinhaber: Thomas Brehmer brehmermechatronics, 51674 Wiehl (DE)
(72) Erfinder: Blättermann, Dennis, 51580 Reichshof (DE); Brehmer, Thomas, 51674 Wiehl (DE)
(74) Vertreter: Lippert, Stachow & Partner

(56) Entgegenhaltungen:
- EP-A1- 2 048 781
- US-A- 5 607 048

## Beschreibung

Die Erfindung betrifft einen Grundkörper für einen kapazitiven Schalter mit flacher Betätigungsfläche zum Auslösen des Schalters nach dem Oberbegriff von Anspruch 1.

Entsprechende Grundkörper werden für kapazitive Schalter verwendet, die in verschiedensten Anwendungsbereichen eingesetzt werden. Solche kapazitiven Schalter werden beispielsweise für das Ein- und Ausschalten von Maschinen, wie etwa Zerkleinerungsvorrichtungen oder Transportbändern, oder etwa als Signalgeber, wie beispielsweise als Haltewunschtaster oder Türöffnungstaster in öffentlichen Verkehrsmitteln eingesetzt.. Die Schalter weisen eine flache Betätigungsfläche auf, wobei die Schalter mittels einer Berührung der Betätigungsfläche oder einer Annäherung an die Betätigungsfläche ausgelöst werden. Hierzu weist ein herkömmlicher Grundkörper für einen solchen kapazitiven Schalter eine Platine mit einer Schaltungselektronik auf, wobei die Platine in einem von dem Grundkörper umfassten Basisteil so angeordnet ist, dass die Schaltungselektronik von der Betätigungsseite aus betätigbar ist. Zum Schutz der Platine ist dabei das Basisteil so ausgebildet, dass es eine Grundplatte mit einer Innen- und Außenseite aufweist sowie eine Umwandung, wobei die Umwandung und die Platine an der Innenseite der Grundplatte angeordnet sind. Die Umwandung erstreckt sich axial zu der Grundplatte, d. h. im Wesentlichen senkrecht zu der durch die flächige Erstreckung der Grundplatte definierten Ebene. Die Umwandung kann beispielsweise kontinuierlich sein. In herkömmlichen Schaltern dient die Umwandung beispielsweise der Fixierung der Grundplatte in dem Grundkörper und/oder dem Schutz der Platine/der Schaltungselektronik. In herkömmlichen Schaltern ist die Grundplatte zumindest abschnittsweise transparent, so dass einer den kapazitiven Schalter betätigenden Person von der Innenseite der Grundplatte aus optische Signale übermittelt werden können, die über das Auslösen des Schalters oder den Betriebszustand des Schalters, wie etwa die Betriebsbereitschaft oder die Schalterstellung, informieren können.

Bei herkömmlichen Grundkörpern für einen kapazitiven Schalter hat sich insbesondere die Anordnung der Platine in dem Basisteil und die entsprechende Gestaltung des Basisteils als problematisch herausgestellt. So muss die Platine mit der Schaltungselektronik so an der Innenseite der Grundplatte angeordnet sein, dass zwischen der Außenseite der Grundplatte und der Schaltungselektronik eine elektronische Koppelung gewährleistet ist, so dass durch eine Berührung der oder Annäherung an die Außenseite der Grundplatte der kapazitive Schalter ausgelöst werden kann. Außerdem muss die Platine verrutschsicher in dem Basisteil fixiert sein, u. a. um eine Beschädigung der Platine und/oder eine Beeinträchtigung der Funktion des Schalters durch das Verrutschen zu verhindern. Bei der Fixierung der Platine in dem Basisteil stellt sich weiterhin das Problem, dass die von der Innenseite übermittelten optischen Signale über den Betriebszustand des kapazitiven Schalters durch dafür vorgesehene transparente Abschnitte in der Grundplatte zu der von der Außenseite der Grundplatte aus bedienenden Person gelangen können. Oftmals sind bei herkömmlichen Schaltern an der Außenseite der Grundplatte Strukturierungen vorgesehen, die zur Übermittlung von Informationen mit von der Innenseite der Grundplatte ausgestrahlten Lichtsignalen zusammenwirken. Beispielsweise sind in einigen herkömmlichen Grundkörpern an der Außenseite der Grundplatte Einkerbungen vorgesehen, die mit an der Innenseite der Grundplatte angeordneten Leuchtelementen zusammenwirken. Aus den genannten Beispielen ist offensichtlich, dass bei der Fixierung der Platine in dem Basisteil häufig eine bestimmte Ausrichtung der Platine in dem Basisteil gewährleistet sein muss. Außerdem muss sichergestellt sein, dass durch die Fixierung selbst, wie etwa durch die zur Fixierung verwendeten Mittel, keine nachhaltige Beeinträchtigung der beschriebenen elektronischen Kopplung und/oder Übermittlung von optischen Signalen erfolgt. Weiterhin muss die Fixierung so durchgeführt sein, dass die Platine durch die Fixierung nicht beschädigt wird.

In herkömmlichen Körpern für kapazitive Schalter wird den genannten Problemen mit technisch aufwendigen und kostspieligen Maßnahmen begegnet. So ist die Grundplatte häufig durchgehend transparent gestaltet, und dekorative Elemente sind nicht in der Grundplatte des Basisteils sondern direkt auf der der Grundplatte zugewandten Seite der Platine angeordnet, so dass eine Ausrichtung der Platine in dem Basisteil entfallen kann. Dies erlaubt jedoch zum einen kein Zusammenwirken von Strukturierungen auf der Grundplatte mit an der Innenseite der Grundplatte angeordneten Signalemittern, zum anderen ist eine kostenintensive dekorative Nachbearbeitung der Platine notwendig, wodurch für einen jeden Schalter je nach Anwendungszweck und der entsprechend erforderlichen Dekoration eine individuelle Platine gefertigt werden muss. Falls zusätzlich oder stattdessen ein Zusammenwirken zwischen einer Strukturierung auf der Grundplatte und optischem Signal hergestellt werden soll, ist eine aufwendige Ausrichtung der Platine in dem Basisteil während der Fixierung der Platine erforderlich.

Zudem wird bei der Fixierung der Platine in dem Basisteil zumeist ein transparenter Spritzguss, insbesondere Zweikomponentenguss verwendet, damit die Übermittlung von optischen Signalen von der Innenseite der Grundplatte zur Außenseite hin nicht beeinträchtigt wird. Die zwingende Verwendung eines solchen transparenten Spritzgusses, bzw. Zweikomponentengusses bringt jedoch weitere Nachteile mit sich: So kann ein solcher Spritzguss, bzw. Zweikomponentenguss beispielsweise nur mit hohem Zeitaufwand realisiert werden, und weiterhin erfolgt dieser Spritzguss, bzw. Zweikomponentenguss bei hohen Drücken von bis zu 200 bar und hohen Temperaturen von über 200 °C, so dass bei der Fixierung leicht eine Beschädigung der Platine, insbesondere der Lötstellen auf der Platine, auftreten kann.

Aus dem Dokument EP 2 048 781 A1 ist ein kapazitiver Schalter mit flacher Betätigungsfläche zum Auslösen des Schalters bekannt, wobei die Betätigungsfläche durch eine ebene Scheibe bereitgestellt wird, und wobei an der der Betätigungsfläche gegenüberliegenden Seite der Scheibe eine Platine auf einem Lichtleiter angeordnet ist, der eine Erhebung aufweist, die mit einer Aussparung in der Platine korrespondiert zum Fixieren der Platine. Die Platine weist eine LED auf, die in einer Aussparung des Lichtleiters angeordnet ist und Licht in den Lichtleiter aussendet, über den dann Licht auf die Scheibe, die die Betätigungsfläche bereitstellt, abgestrahlt wird.

Ausgehend von dem Stand der Technik liegt der Erfindung die Aufgabe zugrunde, einen Grundkörper für einen kapazitiven Schalter mit flacher Betätigungsfläche zum Auslösen des Schalters bereitzustellen, durch den die oben beschriebenen Probleme und Nachteile herkömmlicher Grundkörper zumindest teilweise behoben werden.

Als eine Lösung der genannten technischen Aufgabe schlägt die Erfindung einen Grundkörper für einen kapazitiven Schalter mit den Merkmalen von Anspruch 1 vor.

Ein erfindungsgemäßer Grundkörper zeichnet sich dadurch aus, dass die Grundplatte des Basisteils des Grundkörpers an ihrer Innenseite zumindest eine axiale Erhebung aufweist, und dass die Platine Aussparungen aufweist, wobei die Erhebungen der Grundplatte in den Aussparungen der Platine angeordnet sind.

Die Erhebungen an der Innenseite der Grundplatte können als Vorsprünge ausgestaltet sein, wobei die Vorsprünge sowohl einstückig mit der Grundplatte gefertigt sein können als auch durch ein oder mehrere getrennt von der Grundplatte hergestellte und nachträglich mit dem Basisteil verbundene Bauteile realisiert sein können. Für die Erhebungen können verschiedene Gestaltungen sinnvoll sein, insbesondere müssen nicht alle Erhebungen oder Vorsprünge der Grundplatte eine identische Geometrie aufweisen. Beispielsweise kann es vorteilhaft sein, wenn die Erhebung zylinderförmig ausgestaltet ist, rechteckig oder auf sonstige Art und Weise. Insbesondere kann es vorteilhaft sein, dass die Erhebungen aus transparentem Material gefertigt sind, damit die Ausbreitung von Licht, insbesondere von Signalemittern emittiertes, nicht durch die Erhebungen beeinträchtigt wird.

Die Aussparungen in der Platine sind so ausgestaltet, dass die Erhebungen des Basisteils in den Aussparungen anordenbar sind. Die Aussparungen können so ausgestaltet sein, dass sie die Erhebungen des Basisteils bündig, insbesondere kraftschlüssig umschließen, damit eine gute Fixierung der Platine in dem Basisteil gewährleistet ist. Es kann jedoch auch vorteilhaft sein, ein Spiel zwischen den Aussparungen und den Erhebungen vorzusehen, so dass die Montage der Platine in dem Basisteil erleichtert ist. Aussparungen und Erhebungen können auch so ausgestaltet sein, dass verschiedene Ausrichtungen der Platine in dem Basisteil möglich sind.

Dadurch, dass die Erhebungen des Basisteils in den Aussparungen der Platine angeordnet sind, kann eine Ausrichtung der Platine in dem Basisteil durch einfaches Einsetzen der Platine in das Basisteil durchgeführt werden. Dadurch kann beispielsweise die Übertragung von optischen Signalen von der Innenseite der Grundplatte zur Außenseite sichergestellt sein, indem die durch die Platine angesteuerten und u. U. auf der Platine angeordneten Signalemitter mit transparenten Stellen der Grundplatte korrespondieren. Entsprechend kann beispielsweise für die Fixierung der Platine in dem Basisteil auch nicht-transparentes Material verwendet werden, wenn sichergestellt ist, dass das Material nicht zwischen den Signalemitter und die transparenten Stellen gelangt. Durch die Ausrichtung der Platine in dem Basisteil kann beispielsweise auch das Zusammenwirken von Strukturierungen auf der Innen- und/oder Außenseite der Grundplatte mit von der Platine angesteuerten Signalemittern gewährleistet sein. Unabhängig von weiteren Merkmalen kann durch das Zusammenwirken von Aussparungen und Erhebungen eine sehr gute und/oder einfache Fixierung der Platine in dem Basisteil bereitgestellt werden.

Vorteilhafterweise können die Erhebungen an der Innenseite der Grundplatte des Basisteils derart ausgebildet sein, dass die Außenseite jeweils zugeordnete Senken aufweist. In diesem Fall sind die Erhebungen einstückig mit der Grundplatte des Basisteils gefertigt. Die Erhebungen können beispielsweise kugelkalottenartig, zylinderförmig oder quaderförmig ausgestaltet sein. Die Senken an der Außenseite der Grundplatte können eine Strukturierung darstellen, die mit optischen Signalemittern, die an der Innenseite der Grundplatte, d. h. von der Innenseite der Grundplatte aus, Licht emittieren und von der Platine angesteuert sind, zusammenwirken. Weiterhin kann beispielsweise durch die kugelkalottenartige Ausgestaltung der Erhebungen und die zugeordneten Senken sichergestellt sein, dass bei dem Herstellungsprozess der Grundplatte keine Beschädigung oder Schwächung des Grundplattenmaterials im Bereich der Erhebungen bzw. Senken auftritt. So ist beispielsweise bekannt, dass bei der Herstellung mittels Spritzgussverfahrens beim Aushärten ein Materialeinfall an rückseitigen Seiten zu Materialanhäufungen, wie etwa Erhebungen, auftreten kann. Dies kann beispielsweise durch die kugelkalottenartige Ausgestaltung der Erhebungen und der zugeordneten Senken rückseitig zu den Erhebungen vermieden werden. Weiterhin ist dadurch, dass einer Senke jeweils eine Erhebung zugeordnet ist, vermieden, dass an den Stellen der Senken eine Materialschwächung in der Grundplatte vorliegt. Denn durch die erfinderische Ausgestaltung ist die Dicke der Grundplatte an den Stellen, an denen die Senken angeordnet sind, nicht verringert. Dadurch ist eine Schwächung der Grundplatte, die beispielsweise auch bei herkömmlichen Strukturierungen der Grundplatte auftreten, wirksam vermieden.

Außerdem kann auf der der Innenseite der Grundplatte des Basisteils abgewandten Seite der Platine zumindest eine LED angeordnet sein, die mit zumindest einer Aussparung fluchtet, wobei die Aussparung als durchgängiges Loch in der Platine ausgebildet ist. Dadurch kann die Erhebung an der Innenseite der Grundplatte, die in der Aussparung der Platine angeordnet ist, als Lichtleiter wirken, durch den das Licht von der LED zu der Außenseite der Grundplatte gelangen kann. Damit kann beispielsweise durch die LED eine Information über den Betriebszustand des Schalters an eine den Schalter bedienende Person übermittelt werden. Beispielsweise können mehrfarbige LEDs verwendet werden, so dass die LED je nach Betriebszustand des Schalters Licht einer bestimmten Wellenlänge bzw. in einem bestimmten Wellenlängenbereich emittiert. Auch kann das Ein- und Ausschalten der Emission der LED in Abhängigkeit von dem Betriebszustand gesteuert sein. Beispielsweise können so je nach Betriebszustand eine oder mehrere LEDs einen bestimmten Bereich der Grundplatte beleuchten, der möglicherweise mit graphischen Informationen für den Benutzer des Schalters versehen ist.

Um eine möglichst gute Lichtleitung mittels der Erhebung durch die Aussparung der Platine zu gewährleisten, kann es vorteilhaft sein, wenn die LED direkt auf der Platine und/oder in Kontakt mit der Erhebung angeordnet ist. Auch kann es vorteilhaft sein, die Erhebungen und Aussparungen so auszugestalten, dass die Erhebungen bzw. Vorsprünge jeweils bündig an der Begrenzungsfläche der jeweiligen Aussparung anliegen, um ein Eindringen von lichtabsorbierendem, streuendem oder nicht transparentem Material zu verhindern.

In einer vorteilhaften Ausführungsform ist zwischen der Innenseite der Grundplatte des Basisteils und der Platine ein scheibenförmiges Dekorationselement angeordnet. Dadurch können von der Außenseite der Grundplatte aus in den transparenten Abschnitten der Grundplatte auf dem Dekorationselement abgebildete graphische Abbildungen sichtbar sein, wobei die Platine zumindest an den transparenten Abschnitten der Grundplatte von dem Dekorationselement verdeckt sein kann. Dadurch ist eine sehr einfache Dekoration des kapazitiven Schalters möglich, ohne dass Strukturierungen an dem Basisteil und/oder eine Bearbeitung der Platine, wie etwa eine Lackierung der Platine, erforderlich sind. Zudem kann das Schalterdesign durch einen Wechsel des Dekorationselementes verändert werden, so dass für kapazitive Schalter für verschiedene Anwendungsbereiche die identischen Basisteile und Platinen verwendet werden können und lediglich ein Austausch des Dekorationselementes erfolgen kann. Dadurch ist insbesondere eine günstigere Herstellung der Platinen und Basisteile des Grundkörpers für einen kapazitiven Schalter möglich.

Vorteilhafterweise kann das Dekorationselement die Innenseite der Grundplatte des Basisteils vollständig mit Ausnahme der Erhebungen bedecken, wobei in dem Dekorationselement Aussparungen vorgesehen sind, durch die sich die Erhebungen des Basisteils hindurch in Richtung zur Platine erstrecken. Dadurch kann gewährleistet sein, dass die Platine für den Benutzer des kapazitiven Schalters nicht sichtbar ist. Die Erhebungen können beispielsweise als Lichtleiter wirken, so dass Lichtsignale von der Innenseite der Grundplatte aus mittels der Erhebungen durch die Aussparungen in dem Dekorationselement an die Außenseite der Grundplatte gelangen können. Außerdem können die Erhebungen die Ausrichtung des Dekorationselementes in dem Basisteil erlauben, so dass die graphischen Darstellungen des Dekorationselementes drehorientiert in dem Basisteil angeordnet sind.

Vorteilhafterweise ist das Basisteil als ein an einer Seite offener Hohlzylinder ausgebildet. Die Zylinderwand muss dabei nicht vollständig geschlossen sein. Durch die entsprechende topfartige Ausgestaltung des Basisteils kann die Platine, die auf der Grundplatte, die den Topfboden darstellt, angeordnet ist, sehr gut geschützt sein.

Vorteilhafterweise kann die Platine als vier-lagige Platine ausgebildet sein, wobei die der Innenseite der Grundplatte zugewandte Außenseite der Platine eine leitende, kapazitive Sensorfläche aufweist. Dadurch ist kein nachträgliches Verlöten von Platinen, die beispielsweise zwei-lagig ausgebildet sind und/oder von denen beispielsweise eine die kapazitive Sensorfläche umfasst und eine weitere die Schaltungselektronik, nötig.

Auch kann die Platine in dem Basisteil mit einem Niederdruck-Niedertemperatur-Verspritzwerkstoff fixiert sein. Dadurch ist eine sehr einfache, kostengünstige und materialschonende Fixierung der Platine in dem Basisteil möglich. Das Niederdruck-Niedertemperatur-Verspritzverfahren ist ein Verspritz- oder Vergussverfahren, in dem Schmelzklebstoffe Anwendung finden. Die Verarbeitungszeit für einen Zyklus eines solchen Verfahrens und die bei dem Verfahren verwendeten Drücke liegen zwischen den Zeiten bzw. Drücken, die bei einem herkömmlichen Spritzguss- und bei einem herkömmlichen Vergussverfahren angewendet werden. Das Verspritzen oder Vergießen des Niederduck-Niedertemperatur-Verspritzwerkstoffes erfolgt üblicherweise bei Temperaturen von ca. 150 bis 200 °C und Drücken von ca. 10 bis 50 bar. Insbesondere hat sich als vorteilhaft herausgestellt, den Verspritzprozess bei ca. 180 °C und ca. 20 bar durchzuführen. Dadurch kann eine Beschädigung der Platine, insbesondere der Lötstellen auf der Platine, sicher vermieden werden. Im Vergleich zu dem herkömmlichen Vergießen mit einem Zweikomponentenharz, wie etwa einem Epoxid-Harz, kann die Fixierung somit deutlich schonender und schneller erfolgen. Als Niederdruck-Niedertemperatur-Verspritzwerkstoff ist beispielsweise die Verwendung von thermoplastischem Elastomer (TPE) der Firma Bayer oder Macromelt der Firma Henkel möglich. Beispielsweise kann bei dem Verspritzvorgang die Platine durch einen Niederhalter in dem Basisteil fixiert sein, so dass es nicht zu einer Aufschwemmung der Platine kommen kann, die ein Eindringen des Verspritzwerkstoffes zwischen Platine und Grundplatte und/oder LEDs und Erhebungen und/oder Dekorationselement und Grundplatte begünstigen würde. Die Platine kann während des Verspritzprozesses beispielsweise auch durch zuvor realisierte Fixierpunkte, wie etwa Klebepunkte in dem Basisteil gehalten sein. Insbesondere dann, wenn durch die Anordnung in dem Grundkörper ein Lichtkanal zwischen einem signalemittierenden Element und der Außenseite der Grundplatte sichergestellt ist, kann auch ein nicht transparenter Verspritzwerkstoff für die Fixierung der Platine in dem Basisteil verwendet werden.

In einer vorteilhaften Ausführungsform umfasst der erfindungsgemäße Grundkörper weiterhin ein Montageelement, in dem das Basisteil angeordnet ist, wobei das Montageelement eine Montageseite aufweist zum Anlegen an einen externen Körper für eine Montage an dem Körper. Das Basisteil kann zumindest abschnittsweise radial innerhalb des Montageelementes angeordnet und gehaltert sein, wobei das Montageelement einen sich radial erstreckenden Montagebereich umfasst, dessen eines axiales Ende an der Montageseite liegt. Durch das Vorsehen eines entsprechenden Montageelementes ist eine sehr einfache Montage des Grundkörpers an einem externen Körper möglich. Die Montageseite des Montageelementes liegt in dem montierten Zustand des Grundkörpers an dem externen Körper zumindest abschnittsweise an, wobei die Montageseite beliebige Flächenabschnitte umfassen kann. Beispielsweise kann die Montageseite eine ringförmige Fläche oder Abschnitte einer ringförmigen Fläche des Montageelementes umfassen. Das Montageelement kann an dem externen Körper beispielsweise dadurch fixiert sein, dass eine Klebefolie an von der Montageseite umfassten Flächenabschnitten angeordnet ist, mit welcher eine kraftschlüssige Verbindung zwischen dem externen Körper und dem Montageelement herstellbar ist. Dadurch, dass das Basisteil zumindest abschnittsweise radial innerhalb des Montageelementes angeordnet und gehaltert ist, ist eine sehr sichere Befestigung des Basisteils in dem Montageelement realisierbar. Zwischen der Montageseite des Montageelementes und dem externen Körper können auch weitere Bauteile, wie etwa ein Dichtelement, insbesondere in Form eines Dichtrings, angeordnet sein. Auch kann zwischen der Montageseite des Montageelementes und dem externen Körper ein Dekorationselement angeordnet sein, so dass bei der Montage an einem transparenten externen Körper bei der Betrachtung des externen Körpers die von dem Dekorationselement bedeckten Flächen der Montageseite nicht sichtbar sind.

Die Erfindung umfasst auch einen wie in dem vorangehenden Absatz beschriebenen Grundkörper, in dem das Basisteil als herkömmliches Basisteil ausgestaltet ist, das mit dem Montageelement entsprechend korrespondiert. Im Vergleich zu herkömmlichen Grundkörpern ist eine kostengünstige Herstellung des entsprechenden erfinderischen Grundkörpers und/oder eine einfache Montage ermöglicht. Auch die im Folgenden beschriebenen vorteilhaften Merkmale sind auf diesen Teil der Erfindung anwendbar.

Das Basisteil und das Montageelement können integral hergestellt sein. Damit können Basisteil und Montageelement in einem Herstellungsschritt gefertigt werden, was eine besonders günstige Herstellung von Basisteil und Montageelement ermöglichen kann. Ferner entfällt die Befestigung des Basisteils am Montageelement.

Das Montageelement kann jedoch auch einen im Wesentlichen ringförmigen Bereich mit einer Innenmantelfläche aufweisen, radial innerhalb dessen das Basisteil angeordnet ist, wobei das Basisteil zumindest ein umfänglich außen angeordnetes erstes Halteelement aufweist, und wobei das Montageelement zumindest ein zweites Halteelement an der Innenmantelfläche des Montageelementes aufweist, das mit dem zumindest einen ersten Halteelement korrespondiert. In dieser Ausführungsform sind das Basisteil und das Montageelement voneinander getrennt hergestellte Bauteile. Der im Wesentlichen ringförmige Bereich umschließt das Basisteil zumindest abschnittsweise und bildet einen Rahmen zur Halterung des Basisteils. Der im Wesentlichen ringförmige Bereich kann dabei auch polygonförmig ausgestaltet sein. Der Bereich weist eine solche axiale Erstreckung auf, dass eine sichere Halterung des Basisteils über das an der Innenmantelfläche angeordnete zweite Halterelement und das an dem Basisteil angeordnete erste Halteelement sichergestellt ist. Die Halteelemente müssen dabei jeweils nicht zwingend umfänglich geschlossen sein.

Vorteilhafterweise sind Basisteil und Montageelement so ausgestaltet, dass das Basisteil in dem Montageelement sowohl so anordenbar ist, dass die Außenseite der Grundplatte zu der Montageseite weist, als auch so, dass die Außenseite der Grundplatte von der Montageseite weg weist, wobei Basisteil und Montageelement zumindest in dem an dem externen Körper montierten Zustand zueinander fixiert sind. Hierzu sind insbesondere die axialen Erstreckungen von Basisteil und Montageelement und/oder die Anordnung von erstem und zweitem Halteelement besonders aufeinander abgestimmt. Beispielsweise können einem ersten Halteelement zwei an der Innenmantelfläche axial versetzt angeordnete zweite Halteelemente zugeordnet sein, so dass die beiden beschriebenen Anordnungen des Basisteils in dem Montageelement realisierbar sind. Ebenso können einem zweiten Halteelement zwei axial versetzte erste Halteelemente zugeordnet sein. Je nach Anordnung kann dann beispielsweise jeweils ein erstes bzw. zweites Halteelement mit einem zweiten bzw. ersten Halteelement verrasten. Auch kann beispielsweise das erste Halteelement axial mittig an dem Basisteil angeordnet sein, so dass die beiden beschriebenen Anordnungen realisierbar sind. Auch können erste Halteelemente und zweite Halteelemente so ausgebildet sein, dass durch ein relatives Verdrehen des Basisteils die jeweilige Anordnung des Basisteils in dem Montageelement realisierbar ist.

Durch die beschriebene Ausgestaltung von Basisteil und Montageelement mit den beiden Anordnungsmöglichkeiten kann das Basisteil in dem Montageelement sowohl so angeordnet sein, dass die Außenseite der Grundplatte, und damit die Betätigungsseite des zugeordneten kapazitiven Schalters, in der Montageseite liegt, als auch so, dass sie von der Montageseite weg weist. Dies ist insbesondere deswegen vorteilhaft, da kapazitive Schalter je nach spezifischer Anwendung entweder an einem externen Köper befestigt sind und von der Schalterseite aus betätigt werden oder an einem transparenten externen Körper befestigt sind und durch Berührung des externen Körpers oder eine Annäherung an den Körper betätigt werden. Die entsprechenden Montageanordnungen des kapazitiven Schalters auf einem externen Körper werden üblicherweise als Aufkörpermontage bzw. Hinterkörpermontage bezeichnet.

Die beschriebene vorteilhafte Ausführungsform mit den beiden Anordnungsmöglichkeiten ermöglicht es, für die Herstellung eines Grundkörpers für eine Aufkörpermontage dieselben Werkzeuge, bei der Herstellung mittels Spritzguss insbesondere Spritzgusswerkzeuge, wie für die Herstellung eines Grundkörpers für einen kapazitiven Schalter zur Hinterkörpermontage zu verwenden. Für spezielle Ausgestaltungen von Basisteil und/oder Montageelement für die jeweiligen Montageanordnungen können dann zusätzliche Werkzeuge für die Herstellung verwendet werden.

Das erste Halteelement des Basisteils kann als umfänglich verlaufender Halteflansch ausgebildet sein. Der Halteflansch muss dabei nicht zwingend kontinuierlich verlaufen. Der Halteflansch kann mit einem entsprechenden zweiten Halteelement des Montageelementes zusammenwirken. Beispielsweise kann die Halterung des Basisteils über den Halteflansch in dem Montageelement dadurch realisiert sein, dass eine Presspassung zwischen dem Halteflansch und der Innenmantelfläche des Montageelementes hergestellt ist, wobei die Innenmantelfläche des Montageelementes als zweites Halteelement wirkt. Auch kann der Halteflansch mit zweiten Halteelementen wie etwa Rastelementen, Flanschen oder Kragen zusammenwirken.

Der Halteflansch des Basisteils kann in Form von Noppen ausgebildet sein. Die Noppen können dabei umfänglich und/oder axial voneinander beabstandet sein. Beispielsweise können die Noppen zylinderförmig, kugelkalottenförmig oder quaderförmig ausgestaltet sein.

Der Halteflansch des Basisteils kann auch so ausgestaltet sein, dass der axiale Abstand von der Außenseite der Grundplatte des Basisteils zu dem Halteflansch im Wesentlichen identisch ist mit dem axialen Abstand zwischen dem der Außenseite gegenüberliegenden axialen Ende des Basisteils und dem Halteflansch. Beispielsweise kann dann, wenn der Halteflansch in Form von Noppen ausgebildet ist, die teilweise axial voneinander beabstandet sind, der jeweilige axiale Abstand von der Außenseite der Grundplatte bzw. von dem der Außenseite gegenüberliegenden axialen Ende des Basisteils zu der axial nächstliegenden Noppe identisch sein. Auch bei sonstigen Ausgestaltungen des Halteflansches können die beschriebenen axialen Abstände jeweils von dem jeweiligen axialen Ende des Basisteils zum nächstliegenden axialen Ende des Haltflansches identisch sein.

Bei dieser vorteilhaften Ausgestaltung des Halteflansches kann somit sehr einfach gewährleistet sein, dass das Basisteil in dem Montageelement sowohl so angeordnet sein kann, dass die Außenseite der Grundplatte an der Montageseite liegt, als auch so, dass sie an dem entgegen gesetzten Ende des Montageelementes liegt, wobei Basisteil und Montageelement zumindest bei dem an dem externen Körper montierten Zustand zueinander fixiert sind. Denn durch das Vorsehen entsprechender Einrichtungen wie Rastelemente, Halteflansche oder Haltekragen an der Innenmantelfläche des Montageelementes kann bei der entsprechenden Anordnung des Halteflansches das Basisteil entsprechend unterschiedlich anordenbar sein. Dabei kann es vorteilhaft sein, dass sich die axialen Abstände, die wie beschrieben im Wesentlichen identisch sind, voneinander geringfügig unterscheiden. Beispielsweise ist es möglich, dass bei nur einer der beiden beschriebenen Anordnungsmöglichkeiten von Basisteil und Montageelement bei der Montage ein weiteres Bauteil (beispielsweise eine Klebefolie oder ein Dekorelement) zwischen der Montageseite des Montageelementes und dem externen Körper vorgesehen ist. Wenn durch das Zusammenwirken von erstem Halteelement und zweitem Halteelement zur zumindest zusätzlichen Fixierung des Basisteils eine Anpressung des Basisteils an den externen Körper erfolgt, kann es vorteilhaft sein, wenn sich die jeweiligen axialen Abstände um die Dicke des bzw. der in der einen Montageanordnung zwischen Montageelement und externem Körper eingefügten Bauteils bzw. Bauteile unterscheidet.

In einer weiteren vorteilhaften Ausführungsform umfasst das zweite Halteelement des Montageelementes einen an der Innenmantelfläche des Montageelementes umfänglich verlaufenden Vorsprung, der sich radial von der Innenmantelfläche in Richtung zum Zentrum des ringförmigen Bereichs erstreckt, an dem der Halteflansch des Basisteils im montierten Zustand der Montageanordnung zumindest abschnittsweise anliegt. Der umfänglich verlaufende Vorsprung muss dabei nicht zwingend kontinuierlich sein und kann auch an einem axialen Ende der Innenmantelfläche angeordnet sein. Beispielsweise können Basisteil und Montageelement so ausgestaltet sein, dass durch die Befestigung des Montageelementes an einem externen Körper ein Anpressdruck auf den Halteflansch des Basisteils ausgeübt wird, wodurch das Basisteil an dem Montageelement und damit auch an dem externen Körper fixiert ist. Dies stellt eine sehr einfache Montagemöglichkeit dar.

Der Vorsprung kann auch eine Rastnase umfassen, durch welche dieser mit dem ersten Halteelement zusammenwirkt. Die Fixierung kann durch die Rastnase alleine hergestellt sein, die Rastnase kann jedoch auch die Fixierung des Basisteils in dem Montageelement lediglich unterstützen. Beispielsweise kann durch eine Rastnase bei Vorsehen eines entsprechend ausgestalteten Halteflansches auch ein Verdrehen des Basisteils in dem Montageelement verhindert oder die Ausrichtung des Basisteils in dem Montageelement gewährleistet sein.

Vorteilhafterweise liegt ein axiales Ende des Basisteils an der Montageseite des Montageelementes an, wobei die axiale Erstreckung des Montageelementes von der Montageseite zu der Kontaktfläche zwischen Halteflansch und Vorsprung der axialen Erstreckung des Basisteils von der Montageseite zu der Kontaktfläche zwischen Halteflansch und Vorsprung entspricht. Dadurch ist ein sehr gutes Anpressen des Basisteils gegen den externen Körper und damit eine Fixierung des Basisteils an dem externen Körper und in dem Montageelement sichergestellt.

Vorteilhafterweise ist zwischen dem Montageelement und dem Basisteil eine stoffschlüssige Verbindung mittels eines thermoplastischen Niederdruck-Niedertemperatur-Verspritzwerkstoffs hergestellt. Dies ermöglicht beispielsweise eine sehr einfache Fixierung von Basisteil und Montageelement noch vor der Montage des Grundkörpers an einem externen Körper.

Auch kann ein Niederdruck-Niedertemperatur-Verspritzwerkstoff zumindest abschnittsweise umfänglich geschlossen auf der Montageseite des Montagebereichs des Montageelementes angeordnet sein. Der auf der Montageseite angeordnete Verspritzwerkstoff kann dabei ringförmig oder flächig ausgestaltet sein und/oder eine ebene Oberfläche bilden. Beispielsweise kann der thermoplastische Niederdruck-Niedertemperatur-Verspritzwerkstoff dazu geeignet sein, die Halterung zwischen Basisteil und Montageelement zu verbessern, indem der Verspritzwerkstoff sowohl an der Montageseite als auch zwischen Basisteil und Montageelement angeordnet ist, so dass der Verspritzwerkstoff fest mit dem Montageelement verbunden ist und eine verbesserte Halterung des Basisteils in dem Montageelement ermöglicht. Der auf der Montageseite des Montagebereichs angeordnete Verspritzwerkstoff kann beispielsweise auch dazu angeordnet sein, eine abdichtende Verbindung zwischen dem Grundkörper und einem externen Körper bei der Montage des Grundkörpers herzustellen. Dadurch kann das Eindringen von Feuchtigkeit von der Montageseite aus in den Grundkörper verhindert werden. Auch kann der Verspritzwerkstoff auf der Montageseite möglicherweise eine Zerstörung der Oberfläche des externen Körpers bei der Montage verhindern.

Das Montageelement kann zur Kabeldurchführung innerhalb seines Montagebereichs einen zur Montageseite offenen Rinnenabschnitt aufweisen, der sich radial von der Innenmantelfläche des Montageelementes zum Umfang hin erstreckt, wobei der Rinnenabschnitt an seiner der Innenmantelfläche zugewandten Seite offen und an seiner dem Umfang des Montageelementes zugewandten Seite geschlossen ist. Durch den Rinnenabschnitt kann das Kabel, das zur Strom- und Datenführung mit der Platine verbunden ist, von dem radial innerhalb des Montageelementes liegenden Basisteil in den Montagebereich geführt werden, von dem aus es senkrecht zu der von der Montageseite definierten Ebene aus der Montageseite in Richtung zum externen Körper austreten kann. Dies kann insbesondere dann sinnvoll sein, wenn der Grundkörper des kapazitiven Schalters an der Außenseite eines externen Körpers angebracht wird, wobei das Kabel zur Stromversorgung des Schalters in den Innenbereich des externen Körpers zu führen ist.

Auch kann das Montageelement zur Kabeldurchführung in seinem Montagebereich eine Aussparung aufweisen, die sich radial von der Innenmantelfläche bis zum Umfang des Montagebereichs erstreckt. Durch eine entsprechende Kabeldurchführung kann das stromführende Kabel von der Platine über die Kabeldurchführung aus dem Montagebereich geführt werden, so dass das Kabel seitlich aus dem Grundkörper für den kapazitiven Schalter heraustritt.

In einer besonderen Ausführung kann das Montageelement sowohl eine Kabeldurchführung aufweisen, die sich radial von der Innenmantelfläche bis zum Umfang des Montagebereichs erstreckt, als auch eine Kabeldurchführung innerhalb des Montagebereichs in Form eines zur Montageseite hin offenen Rinnenabschnitts aufweisen. Ein solches Montageelement eignet sich zur Durchführung eines Kabels sowohl in Richtung zum externen Körper als auch seitlich von dem Grundkörper weg, beispielsweise entlang des externen Körpers.

Weiterhin umfasst die Erfindung einen kapazitiven Schalter, der einen wie oben beschrieben Grundkörper aufweist, wobei der Schalter zusätzlich ein Abdeckelement umfasst, das Montageelement innerhalb des Abdeckelementes angeordnet und das Abdeckelement an dem Montageelement befestigt ist. Dabei weist das Abdeckelement einen hohlzylinderförmigen Bereich auf, der sich von der Montageseite aus axial über das Montageelement erstreckt und an dem der Montageseite gegenüberliegenden Ende zumindest abschnittsweise geschlossen ist, wobei das Montageelement radial innerhalb des hohlzylinderförmigen Bereichs in dem Abdeckelement befestigt ist und zumindest abschnittsweise an seinem der Montageseite abgewandten Ende von dem Abdeckelement bedeckt ist.

Das Abdeckelement kann beispielsweise als Dekorationselement und/oder zum Schutz des Schalters dienen, durch das zumindest Abschnitte des Montageelements und möglicherweise auch Abschnitte des Basisteils bedeckt sind. Dabei ist das Abdeckelement verliersicher an dem Montageelement befestigt. Insbesondere umfänglich kann das Abdeckelement das Montageelement auch vollständig umschließen. Das Abdeckelement kann auch so an dem Montageelement angeordnet sein, dass das Abdeckelement zumindest abschnittsweise im Wesentlichen an dem externen Körper, an dem der kapazitive Schalter montiert ist, anliegt.

Das Abdeckelement kann so ausgebildet sein, dass es das Montageelement und das Basisteil umfänglich und an dem der Montageseite gegenüberliegenden axialen Ende im Wesentlichen vollständig flächig umschließt, wobei die Außenseite der Grundplatte des Basisteils an der Montageseite liegt. Ein solches Abdeckelement eignet sich insbesondere für einen für die Hinterkörpermontage vorgesehenen kapazitiven Schalter. Dabei können Basisteil und Montageelement im Wesentlichen vollständig von dem Montageelement umschlossen sein, wobei die Betätigung des kapazitiven Schalters von der Seite des externen Körpers aus erfolgt. Bei dem Vorsehen eines zumindest abschnittsweise transparenten externen Körpers kann die Außenseite der Grundplatte, die der Betätigungsseite des kapazitiven Schalters entspricht, durch den externen Körper hindurch zumindest abschnittsweise sichtbar sein.

Das Abdeckelement kann auch so ausgestaltet sein, dass es das Montageelement und das Basisteil umfänglich und das Montageelement an dem der Montageseite gegenüberliegenden axialen Ende im Wesentlichen vollständig umschließt, wobei das Abdeckelement die Grundplatte des Basisteils umfänglich umschließt, und wobei die Außenseite der Grundplatte des Basisteils an dem der Montageseite gegenüberliegenden axialen Ende des Schalters liegt. Ein solches Abdeckelement kann für einen für eine Aufkörpermontage geeigneten kapazitiven Schalter vorgesehen sein. Das Abdeckelement kann den Umfang des Montageelementes und die der Montageseite abgewandte Seite des Montageelementes im Wesentlichen vollständig bedecken, so dass es als Dekorationselement zum Bedecken des Montageelementes geeignet ist. Dadurch, dass das Abdeckelement die Grundplatte des Basisteils umfänglich umschließt, ist die Außenseite der Grundplatte für die Betätigung des Schalters zugängig. Vorteilhafterweise können die Außenseite der Grundplatte und die Außenseite des Abdeckelements zumindest an ihren Kontaktstellen in einer Ebene liegen, so dass eine Ablagerung von Schmutz auf der gebildeten, im Wesentlichen glatten Oberfläche des kapazitiven Schalters zumindest teilweise verhindert ist. Die Grundplatte kann jedoch auch über das Abdeckelement herausstehen, so dass ein Benutzer die Außenseite der Grundplatte, die auch die Bedienfläche des kapazitiven Schalters darstellt, leichter ertasten kann. Dieser Effekt kann auch dadurch realisiert sein, dass die Oberfläche der Grundplatte näher an dem externen Körper angeordnet ist als die die Grundfläche umgebende Umrandung des Abdeckelementes, so dass eine Stufe von der Oberfläche des Abdeckelementes an der Umrandung zum Basisteil realisiert ist.

In einer vorteilhaften Ausführungsform weist das Montageelement ein Fixierflansch und das Abdeckelement an der Innenfläche des hohlzylinderförmigen Bereichs Rastelemente auf, wobei Fixierflansch und Rastelemente zur Fixierung des Montageelementes innerhalb des Abdeckelementes miteinander korrespondieren. Durch das Vorsehen von Rastelementen und einem zugeordneten Fixierflansch kann eine sehr einfache Verrastung und Fixierung von Abdeckelement und Montageelement bzw. Grundkörper realisiert sein. Bei einer derartigen Gestaltung von Fixierflansch und Rastelementen kann insbesondere gewährleistet sein, dass das Abdeckelement leicht auf das Montageelement aufgeschoben und mit ihm verrastet werden kann, wenn das Montageelement an einem externen Körper fixiert ist, und gleichzeitig nur unter erheblichem Aufwand von dem Montageelement losgelöst werden kann, wenn das Montageelement an dem externen Körper befestigt ist. Dadurch kann insbesondere bei der Verwendung des kapazitiven Schalters an Stellen mit beliebigem Publikumsverkehr einer Zerstörung des Schalters durch Vandalismus vorgebeugt werden.

Der Fixierflansch des Montageelementes kann so ausgebildet sein, dass der Durchmesser des Fixierflansches axial in Richtung zu der Montageseite hin zunimmt. Dadurch ist ein leichtes Anbringen des Abdeckelementes an dem Montageelement und eine Erschwerung des Abnehmens des Abdeckelementes von dem Montageelement gewährleistet.

Auch können die Rastelemente des Abdeckelements so ausgebildet sein, dass ihre radiale Erstreckung von dem Innenmantelbereich des Abdeckelementes weg axial in Richtung zu der Montageseite hin abnimmt. Dadurch kann insbesondere ein leichtes Anbringen des Abdeckelements an dem Montageelement und eine Erschwerung des Abnehmens des Abdeckelements von dem Montageelement gewährleistet sein.

Außerdem kann an Bereichen des Montageelementes an der Montageseite, die radial außerhalb des Bereichs des Basisteils liegen, eine Klebefolie zur Montage an einem externen Körper vorgesehen sein. Dadurch ist eine sehr einfache und nachhaltige Befestigung des kapazitiven Schalters an dem externen Körper möglich.

Die Erfindung wird im Folgenden durch das Beschreiben von Ausführungsformen unter Bezugnahme auf die beiliegenden Figuren weiter erläutert.

Es zeigt
- Figur 1:: eine perspektivische Ansicht eines von einem erfindungsgemäßen Grundkörper umfassten Basisteils;
- Figur 2:: eine perspektivische Ansicht eines von einem erfindungsgemäßen Grundkörper umfassten Dekorationselementes;
- Figur 3:: eine perspektivische Ansicht einer von einem erfindungsgemäßen Grundkörper umfassten Platine;
- Figur 4:: eine perspektivische Ansicht eines von einem erfindungsgemäßen Grundkörper umfassten Montageelementes mit Sicht auf die Montageseite des Montageelementes;
- Figur 5:: eine perspektivische Ansicht eines erfindungsgemäßen Grundkörpers mit Sicht auf die Montageseite;
- Figur 6:: eine perspektivische Ansicht eines erfindungsgemäßen Grundkörpers mit Sicht auf die Montageseite;
- Figur 7:: eine perspektivische Ansicht eines Abdeckelementes einer ersten Ausführungsform eines kapazitiven Schalters;
- Figur 8:: eine perspektivische Ansicht der ersten Ausführungsform eines kapazitiven Schalters gemäß Figur 7 mit Sicht auf die der Montageseite abgewandte Seite des Schalters;
- Figur 9:: eine Schnittdarstellung der ersten Ausführungsform eines kapazitiven Schalters gemäß Figur 7;
- Figur 10:: eine perspektivische Ansicht eines von einem erfindungsgemäßen Grundkörper umfassten Montageelementes mit Sicht auf die der Montageseite abgewandte Seite des Montageelementes;
- Figur 11:: eine perspektivische Ansicht eines erfindungsgemäßen Grundkörpers mit Sicht auf die Montageseite;
- Figur 12:: eine perspektivische Ansicht eines Abdeckelementes einer zweiten erfindungsgemäßen Ausführungsform eines kapazitiven Schalters;
- Figur 13:: eine perspektivische Ansicht der Ausführungsform des kapazitiven Schalters gemäß Figur 12;
- Figur 14:: eine Schnittdarstellung der Ausführungsform des kapazitiven Schalters gemäß Figur 12.

In den Figuren sind ähnlich wirkende Bauteile mit identischen Bezugszeichen indiziert.

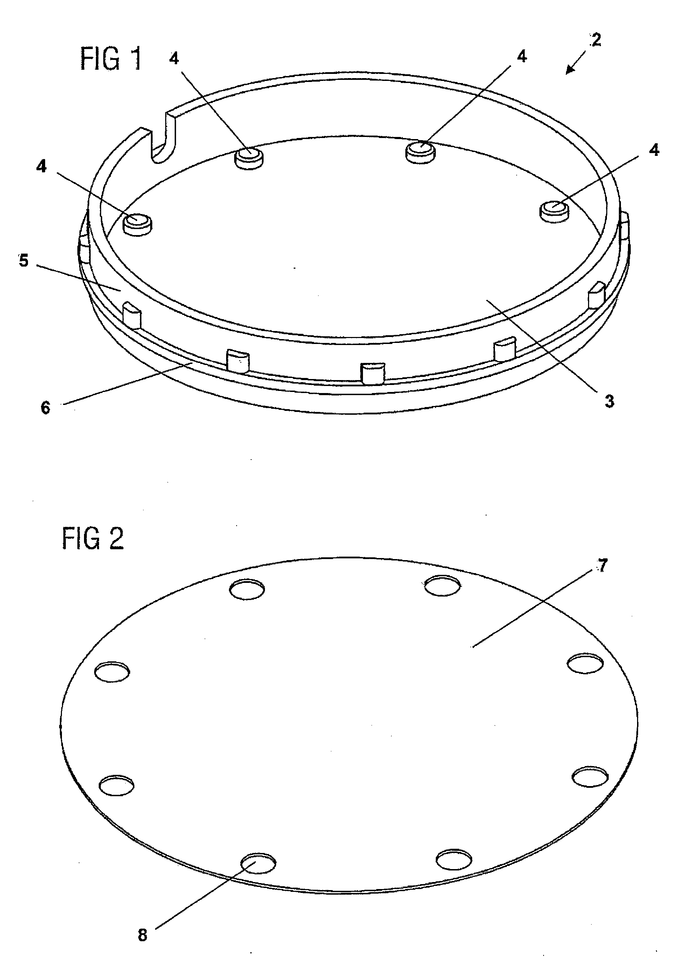

In Figur 1 ist ein von einem erfindungsgemäßen Grundkörper umfasstes Basisteil 2 perspektivisch dargestellt. Das Basisteil 2 umfasst eine Grundplatte 3, die an ihrer Innenseite Erhebungen oder Vorsprünge 4 aufweist. In Figur 1 ist lediglich die Innenseite der Grundplatte 3 sichtbar, die Außenseite liegt auf der in Figur 1 nicht dargestellten Seite der Grundplatte 3. Die Erhebungen 4 können wie dargestellt im Wesentlichen zylinderförmig sein, oder auch eine andere Form aufweisen, insbesondere kugelkalottenartig sein. Die Erhebungen 4 können einstückig mit der Grundplatte 3 gefertigt sein. In der beschriebenen Ausführungsform sind Grundplatte 3 und Erhebungen 4 mittels Spritzguss in einem Spritzgusswerkzeug hergestellt. Dabei sind die Erhebungen 4 transparent, so dass sie als Lichtleiter wirken können. Die Erhebungen 4 können jedoch auch, insbesondere falls sie ausschließlich der Orientierung und/oder Fixierung einer Platine in dem Basisteil 2 dienen, lichtabsorbierend oder reflektierend ausgestaltet sein. Die Grundplatte 3 ist zumindest abschnittsweise transparent. In der beschriebenen Ausführungsform sind Grundplatte 3 und Erhebungen 4 aus einem im sichtbaren Wellenlängenbereich im Wesentlichen transparenten Material hergestellt.

An der Innenseite der Grundplatte 3 ist weiterhin eine Umwandung 5 angeordnet, die sich axial, und somit im Wesehtlichen senkrecht, zu der Grundplatte 3 erstreckt. In der dargestellten Ausführungsform ist die Umwandung 5 umfänglich an der Grundplatte 3 angeordnet, es kann jedoch auch vorteilhaft sein, dass sich die Grundplatte 3 radial über die Umwandung 5 hinaus erstreckt. Die Umwandung 5 weist an einer Seite eine Aussparung auf, die der Durchführung eines Kabels zu einer in dem Basisteil 2 angeordneten Platine dient.

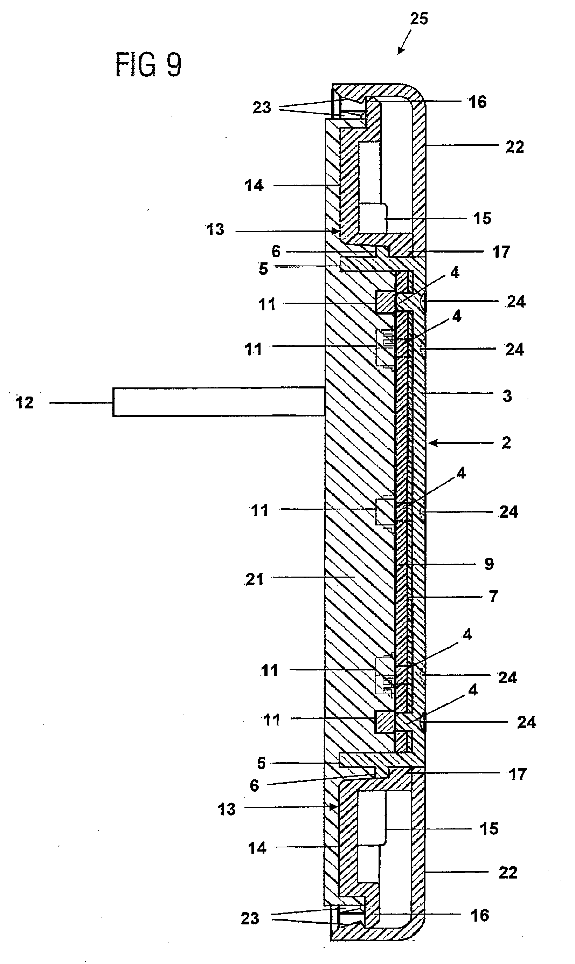

Radial außen an der Umwandung 5 ist ein Halteflansch 6 vorgesehen. In der dargestellten Ausführungsform umfasst der Halteflansch 6 einen kontinuierlich umlaufenden, sich radial nach außen erstreckenden Flansch sowie umfänglich beabstandete Noppen oder Rippen, die sich axial vom Flansch 6 und radial von der Umwandung 5 erstrecken. Der Halteflansch 6 dient der Fixierung des Basisteils 2 in einem Montagelement 13 eines erfindungsgemäßen Grundkörpers 1 und kann zu diesem Zweck entsprechend vorteilhaft ausgestaltet sein. Der Halteflansch 6 wirkt als erstes Halteelement und ist so ausgestaltet, dass er mit einem an dem Montageelement 13 angeordneten zweiten Halteelement zur Fixierung des Basisteils 2 in dem Grundkörper 1 zusammenwirkt, siehe Figur 9. Je nach angestrebter Fixierung und Ausgestaltung des zweiten Halteelementes kann für den Halteflansch 6 eine bestimmte Ausgestaltung besonders vorteilhaft sein, wie etwa eine Ausgestaltung als umfänglich und/oder axial beabstandete Noppen ohne weiteren Flansch, oder eine Ausgestaltung als Flansch ohne Noppen, insbesondere als kontinuierlich umlaufender oder abschnittsweise umlaufender Flansch. Der Halteflansch 6 kann beispielsweise auch als Nut ausgebildet sein, in die ein zweites Halteelement einrastbar ist. Auch können sowohl der Halteflansch 6 als auch das dem Halteflansch 6 zugeordnete zweite Halteelement jeweils als Nut ausgebildet sein, wobei ein weiteres, insbesondere elastisches Bauteil vorgesehen ist, wie etwa ein O-Ring, der die Verbindung zwischen Halteflansch 6 und zweitem Halteelement herstellt.

Umrandung 5 und Halteflansch 6 können jeweils als getrenntes Bauteil gefertigt sein, oder aber auch als integrales Bauteil hergestellt sein. Beispielsweise können Umwandung 5 und Halteflansch 6 auch so ausgebildet sein, dass die Umwandung 5 eine zumindest abschnittsweise umlaufende Nut aufweist und der Halteflansch 6 als ein in die umlaufende Nut einrastbares Halteelement ausgebildet ist. In der beschriebenen Ausführungsform ist das Basisteil 2 integral als einstückiges Bauteil mittels eines Spritzgussverfahrens hergestellt.

In Figur 2 ist ein von einem erfindungsgemäßen Grundkörper 1 umfasstes Dekorationselement 7 perspektivisch dargestellt. Das Dekorationselement 7 ist scheibenförmig ausgebildet und weist Aussparungen 8 auf, die im zusammengesetzten Zustand des Grundkörpers 1 die Erhebungen 4 des Basisteils 2 umgreifen. In der beschriebenen Ausführungsform eines Grundkörpers 1 ist das Dekorationselement 7 an der Innenseite der Grundplatte 3 des Basisteils 2 so angeordnet, dass es unmittelbar auf der Innenseite aufliegt, und dass sich die Erhebungen 4 durch die Aussparungen 8 in dem Dekorationselement 7 hindurch erstrecken. Es ist jedoch beispielsweise auch möglich, zwischen der Innenseite der Grundplatte 3 und dem Dekorationselement 7 weitere Bauteile vorzusehen, beispielsweise um bestimmte Abschnitte des Dekorationselementes 7 zu verdecken. In der beschriebenen Ausführungsform ist das Dekorationselement 7 als auf einer Seite bedrucktes Papier ausgebildet. Das Dekorationselement 7 kann jedoch beispielsweise auch aus einem leitenden Material gefertigt sein und/oder lackiert sein.

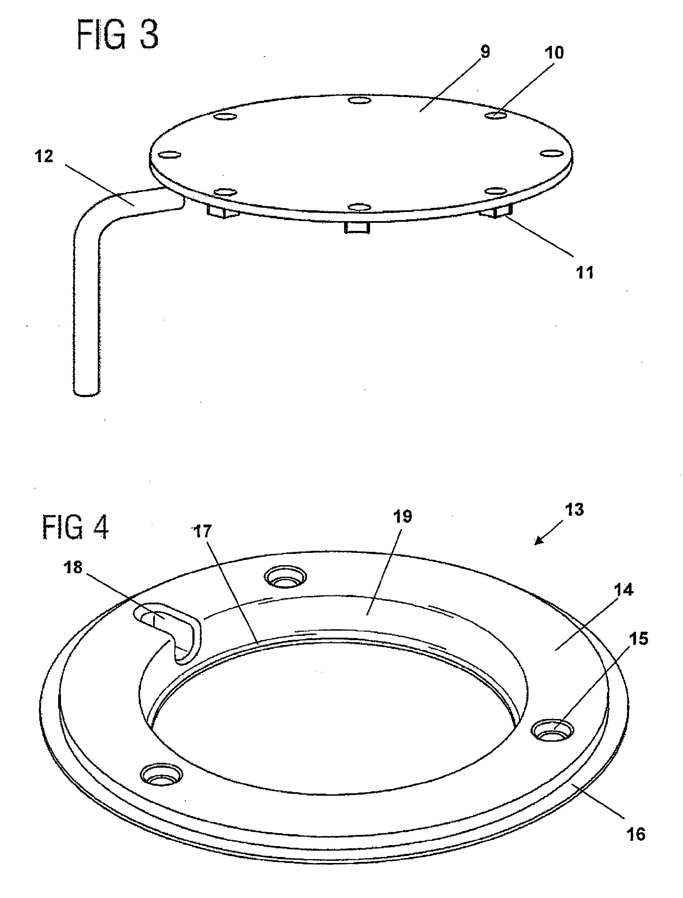

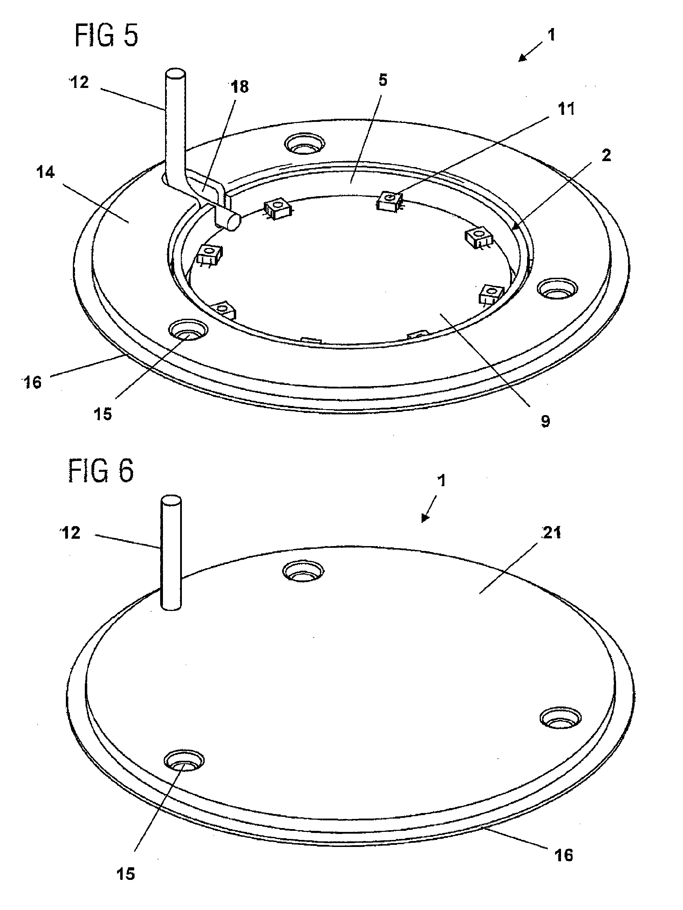

In Figur 3 ist eine von einem erfindungsgemäßen Grundkörper 1 umfasste Platine 9 perspektivisch dargestellt. Die Platine 9 ist als vier-lagige Platine ausgebildet, wobei die der Grundplatte 3 zugewandte Seite eine leitende Sensorfläche umfasst. Die Platine 9 weist Aussparungen 10 auf, die als durch die Platine 9 durchgängige Löcher ausgebildet sind, und mit denen an einer Seite der Platine 9 angeordnete LEDs 11 fluchten. In der dargestellten Ausführungsform ist einer jeden Aussparung 10 eine LED 11 zugeordnet, welche durch die Aussparung hindurch abstrahlt (siehe Figur 5).

In dem beschriebenen erfindungsgemäßen Grundkörper 1 (siehe Figur 5) ist die Platine 9 in einem Basisteil 2 nach Figur 1 so angeordnet, dass die Platine 9 an der Innenseite der Grundplatte 3 anliegt. Dabei ist ein Dekorationselement 7 nach Figur 2 zwischen der Grundplatte 3 und der Platine 9 angeordnet, wobei die LEDs 11 der Platine 9 an der der Grundplatte 3 abgewandten Seite der Platine 9 angeordnet sind. In dem erfindungsgemäßen Grundkörper 1 verlaufen die Erhebungen 4 durch die Aussparungen 8 in dem Dekorationselement 7 und durch die Aussparungen 10 in der Platine 9 zu den LEDs hindurch, wobei die LEDs 11 die Erhebungen 4 berühren. Je nach Ausgestaltung der Erhebungen 4 und der LEDs 11 sowie der Aussparungen 8, 10 kann es auch vorteilhaft sein, dass die einer LED 11 zugewandte Oberseite einer Erhebung 4 von der LED 11 beabstandet ist.

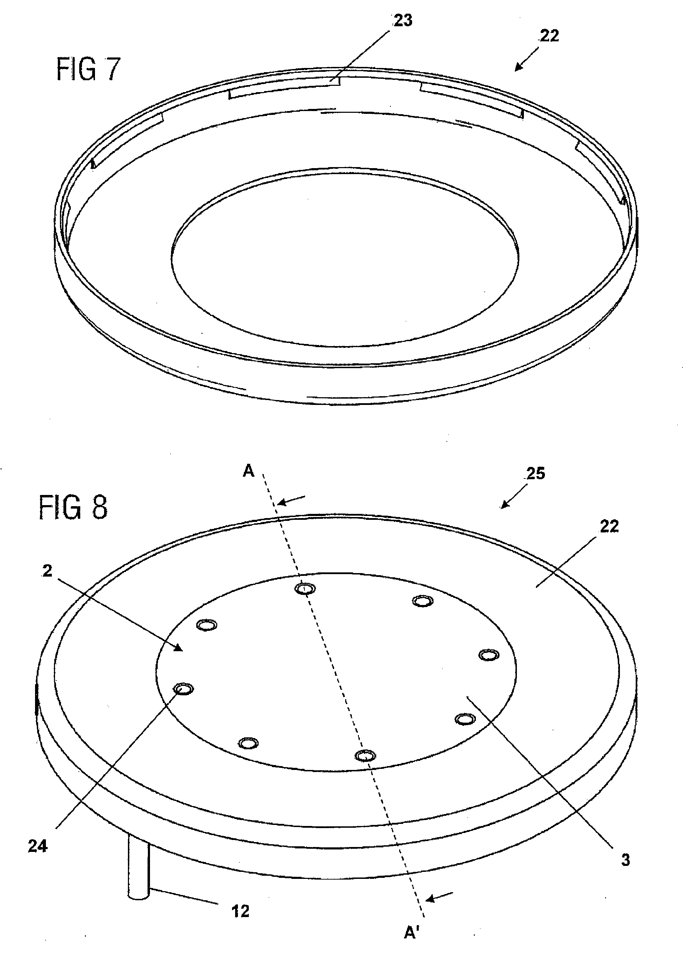

In der beschriebenen Ausführungsform kann das von einer LED 11 emittierte Licht in eine Erhebung 4 eingekoppelt werden, die als Lichtleiter wirkt, wodurch das von der LED 11 emittierte Licht aus der Außenseite der Grundplatte 3 ausstrahlen kann. Durch eine entsprechende Ausgestaltung der Erhebungen 4 und der ihnen zugeordneten Senken 24 an der Außenseite der Grundplatte 3, die beispielsweise in Figur 8 dargestellt sind, kann beispielweise eine Fokussierung des Lichts oder eine Streuung des Licht eingestellt sein. Einer auf die Außenseite der Grundplatte 3 blickenden Person können somit über die LEDs 11 Lichtsignale übermittelt werden, die beispielsweise diese Person über den Betriebszustand eines dem Grundkörper 1 zugeordneten kapazitiven Schalters 25, der beispielhaft in Figur 8 dargestellt ist, informieren. Die Platine 9 wird über ein Kabel 12 mit Strom versorgt. Das Kabel 12 kann durch die Aussparung in der Umwandung 5 des Basisteils 2 aus dem Grundkörper 1 austreten, siehe Figur 1.

In Figur 4 ist ein von einem erfindungsgemäßen Grundkörper 1 umfasstes Montageelement 13 perspektivisch dargestellt. Dabei ist die Sicht auf die Montageseite des Montageelementes 13 dargestellt. Das Montageelement 13 weist einen Montagebereich 14 in Form eines Anlageflansches auf, der zur Montage des Montageelementes 13 an einem externen Körper an diesen zumindest abschnittsweise angelegt wird.

In der dargestellten Ausführungsform weist das Montageelement 13 in seinem Montagebereich 14 Montagedurchlässe 15 auf, durch die Schrauben zur Verschraubung des Montageelementes 13 an dem externen Körper verlaufen können. Beispielsweise können die Montagedurchlässe 15 wie dargestellt zylinderartig ausgestaltet sein, damit eine hohe Stabilität bei der Verschraubung gewährleistet ist. Das Montageelement 13 weist einen ringförmigen Bereich auf, der eine Innenmantelfläche 19 umfasst. An dem der Montageseite abgewandten axialen Ende der Innenmantelfläche 19 ist ein radial nach innen verlaufender Haltekragen 17 angeordnet. Es kann jedoch auch vorteilhaft sein, den Haltekragen 17 an anderer axialer Stelle an der Innenmantelfläche 19 anzuordnen. Der Haltekragen 17 wirkt als zweites Halteelement, das bei dem Einsetzen eines nach Figur 1 beschriebenen Basisteils 2 in das in Figur 4 dargestellte Montageelement 13 mit dem Halteflansch 6 als erstem Halteelement korrespondiert, um eine Fixierung des Basisteils 2 in dem Montageelement 13 zu gewährleisten.

Anstelle des Haltekragens 17 oder zusätzlich zu dem Haltekragen 17 kann das Montageelement 13 auch sonstige zweite Halteelemente aufweisen, die mit entsprechenden ersten Halteelementen des Basisteils 2 zusammenwirken. Beispielsweise kann ein zweites Halteelement als kontinuierlich umlaufende Nut oder umlaufend beabstandete Nuten, als Flansch oder als Rastnase ausgebildet sein.

In der dargestellten Ausführungsform ist die Fixierung des Basisteils 2 in dem Montagelement 13 dadurch gewährleistet, dass der Haltekragen 17 auf den Halteflansch 6 bei dem Verschrauben des Montageelementes 13 an einen externen Körper einen Druck in Richtung zu diesem Körper ausübt, wodurch das Basisteil 2 gegen den externen Körper gepresst wird.

Das Montageelement 13 weist weiterhin in seinem Montagebereich 14 einen Rinnenabschnitt 18 auf, der sich radial von der Innenmantelfläche 19 zum Umfang des Montageelementes 13 hin erstreckt. Der Rinnenabschnitt 18 ist an seiner der Innenmantelfläche 19 zugewandten Seite offen und an seiner dem Umfang des Montageelementes 13 zugewandten Seite geschlossen. Ein an einer in einem Basisteil 2 angeordneten Platine 9 angeordnetes Kabel 12 kann somit durch die Aussparung in der Umwandung 5 des Basisteils 2 in den Rinnenabschnitt 18 austreten und aus diesem im Wesentlichen senkrecht zur Oberfläche des Montagebereichs 14 an der Montageseite austreten. Zur Stromführung kann das Kabel 12 somit in dem externen Körper, an dem das Montageelement 13 montiert ist, angeschlossen werden. An seinem Umfang weist das Montageelement 13 außerdem einen Fixierflansch 16 auf, an dem weitere Bauteile, wie etwa ein in Figur 7 abgebildetes Abdeckelement 22, befestigt werden können.

In Figur 5 ist eine Ausführungsform eines erfindungsgemäßen Grundkörpers 1 mit Sicht auf die Montageseite perspektivisch dargestellt. Der dargestellte Grundkörper 1 umfasst ein Montageelement 13 nach Figur 4. Radial innerhalb des Montageelementes ist ein Basisteil 2 nach Figur 1 angeordnet. In dem Basisteil 2 ist eine Platine 9 nach Figur 4 angeordnet, wobei zwischen der Platine 9 und der Innenseite der Grundplatte 3 ein Dekorationselement 7 nach Figur 2 angeordnet ist. In der beschriebenen Ausführungsform weist die in Figur 5 nicht sichtbare Außenseite der Grundplatte 3 des Basisteils 2 von der Montageseite weg.

In der beschriebenen Ausführungsform sind Basisteil 2 und Montageelement 13 jedoch so ausgestaltet, dass das Basisteil 2 in dem Montageelement 13 auch so anordenbar ist, dass die Außenseite der Grundplatte 3 zu der Montageseite weist. Basisteil 2 und Montageelement 13 sind auch in dieser Anordnung in dem an dem externen Körper montierten Zustand des Grundkörpers 1 zueinander fixiert. In der beschriebenen Ausführungsform wird diese Variabilität dadurch gewährleistet, dass der axiale Abstand von der Außenseite der Grundplatte 3 des Basisteils 2 zu dem Halteflansch 6 identisch mit dem axialen Abstand von dem der Außenseite gegenüberliegenden axialen Ende des Basisteils 2 zu dem Halteflansch 6 ist. Dabei entspricht die axiale Erstreckung des Montageelementes 13 von der Montageseite zu dem Kontaktbereich zwischen Halteflansch 6 und Haltekragen 17 in dem Grundkörper 1 der axialen Erstreckung des Basisteils 2 von der Montageseite zu der Kontaktfläche zwischen Halteflansch 6 und Haltekragen 17 in dem an einem externen Körper montierten Zustand des Grundkörpers 1. Somit wird in der dargestellten Ausführungsform das Basisteil 2 sowohl dann, wenn, wie in Figur 5 dargestellt, die Außenseite der Grundplatte 3 von der Montageseite weg weist, als auch dann, wenn die Außenseite der Grundplatte 3 zu der Montageseite hinweist, über das Zusammenwirken von Halteflansch 6 und Haltekragen 17 an den externen Körper gepresst.

Der beschriebene erfindungsgemäße Grundkörper 1 eignet sich somit sowohl für einen kapazitiven Schalter zur Aufkörpermontage als auch für einen kapazitiven Schalter zur Hinterkörpermontage.. Es kann dabei auch vorteilhaft sein, das Basisteil 2 so auszugestalten, dass die oben beschriebenen axialen Abstände von den jeweiligen axialen Enden des Basisteils zu dem Haltflansch 6 geringfügig unterschiedlich sind. Dies ist insbesondere dann vorteilhaft, wenn bei einer der beiden Montagemethoden, d. h. Aufkörpermontage und Hinterkörpermontage, ein weiteres Bauteil, wie etwa eine Dichtung oder eine Klebefolie, zwischen Basisteil 2 und externem Körper und/oder Montageelement 3 und externem Körper vorgesehen ist.

In dem in Figur 5 dargestellten Grundkörper 1 kann die Platine 9 in dem Basisteil 2 auf vielfältige Art und Weise fixiert sein. Beispielsweise kann sich zur Fixierung ein Sicherungsring eignen, oder ein Spritzgusswerkstoff oder ein thermoplastischer Niederdruck-Niedertemperatur-Verspritzwerkstoff 21. Die zur Fixierung verwendeten Werkstoffe müssen dabei nicht zwingend transparent sein, da durch die erfindungsgemäße Ausgestaltung des Grundkörpers 1 die Übertragung von Lichtsignalen von der Platine 9 zur Außenseite der Grundplatte 3, von der aus der Grundkörper 1 für einen kapazitiven Schalter bedient werden kann, in jedem Falle sichergestellt ist. Außerdem ist durch die Anordnung der Platine 9 über dem Dekorationselement 7 und die Fixierung von Platine 9 und Dekorationselement 7 anhand der Erhebungen 4 sichergestellt, dass der zum Fixieren verwendete Werkstoff sich nicht an transparenten Stellen der Grundplatte 3 ablagern kann, wodurch unerwünschte optische Effekte bei Blick auf den Grundkörper 1 von der Außenseite der Grundplatte 3 vermieden sind.

In Figur 6 ist ein erfindungsgemäßer Grundkörper 1 abgebildet, bei dem an der Montageseite ein thermoplastischer Niederdruck-Niedertemperatur-Verspritzwerkstoff 21 aufgegossen ist. Die Montagedurchlässe 15 sind durch den Niederdruck-Niedertemperatur-Verspritzwerkstoff 21 nicht verschlossen, und das Kabel 12 ist stoffschlüssig mit dem Verspritzwerkstoff 21 verbunden. In der dargestellten Ausführungsform ist der verwendete Verspritzwerkstoff 21 zur Abdichtung geeignet und bildet eine im Wesentlichen ebene Oberfläche, so dass durch die Befestigung des Grundkörpers 1 an einem externen Körper das Eindringen von Feuchtigkeit von der Montageseite her in den Grundkörper 1 verhindert ist.

Dadurch, dass der Verspritzwerkstoff 21 stoffschlüssig mit dem Kabel 12 verbunden ist, ist zudem gewährleistet, dass das Kabel 12 gegen Zerstörung aufgrund einer bereitgestellten Zugbelastung geschützt ist. In der beschriebenen Ausführungsform ist der Verspritzwerkstoff 21 sowohl in dem Basisteil 2 als auch auf der Montageseite des Montageelementes 13 platziert, wobei der Verspritzwerkstoff in einem Arbeitsschritt so aufgebracht ist, dass eine stoffschlüssige Verbindung zwischen Platine 9, Basisteil 2 und Montageelement 13 realisiert ist. Es ist jedoch auch möglich, das Aufbringen des Verspritzwerkstoffs 21 in verschiedenen Arbeitsschritten zu realisieren. Insbesondere kann in einem ersten Arbeitsschritt mit dem Verspritzwerkstoff 21 die Platine 9 mit dem Basisteil 2 fixiert werden und in einem zweiten Arbeitsschritt eine stoffschlüssige Verbindung zwischen Basisteil 2 und Montageelement 13 hergestellt werden. Die stoffschlüssige Verbindung zwischen Montageelement 13 und Basisteil 2 kann auch bei jeder anderen Fixierung von Platine 9 in Basisteil 2 realisiert werden, wie etwa einer Fixierung mittels Sicherungsring und/oder mittels Kraftschluss zwischen Erhebungen 4 und Aussparungen 10.

In Figur 7 ist ein Abdeckelement 22 einer ersten Ausführungsform eines kapazitiven Schalters perspektivisch dargestellt. Das Abdeckelement 22 ist topfartig ausgebildet, wobei es in der Mitte seines Topfbodens eine im Wesentlichen kreisrunde, zentrische Öffnung aufweist. An dem Innenmantelbereich des Abdeckelementes 22 sind sich radial nach innen erstreckende, rippenartige Rastelemente 23 angeordnet. Das Abdeckelement 22 ist an einem erfindungsgemäßen Grundkörper 1, beispielsweise wie in Figur 5 oder Figur 6 dargestellt, anbringbar, indem es von der der Montageseite gegenüberliegenden Seite des Grundkörpers 1 aus axial über den Grundkörper 1 geschoben wird, bis die Rastelemente 23 mit dem Fixerflansch 16 des Grundkörpers 1 so zusammenwirken, dass eine Fixierung des Abdeckelementes 22 an dem Grundkörper 1 gewährleistet ist. Die Rastelemente 23 sind so ausgestaltet, dass ihre radiale Erstreckung von dem Innenmantelbereich des Abdeckelementes 22 axial von dem dem Topfboden mit der Öffnung des Abdeckelementes gegenüberliegendem Ende in Richtung zu dem axialen Ende mit der Öffnung hin zunimmt. Dies ermöglicht ein vereinfachtes axiales Aufschieben des Abdeckelementes 22 auf den Grundkörper 1 und erschwert gleichzeitig das Entfernen des Abdeckelementes 22 von dem Grundkörper 1, nachdem das Abdeckelement 22 einmal mit dem Grundkörper 1 verrastet ist.

In Figur 8 ist eine erste Ausführungsform eines kapazitiven Schalters 25 mit Sicht auf die der Montageseite abgewandte Seite des Schalters 25 perspektivisch dargestellt. Der dargestellte kapazitive Schalter 25 eignet sich insbesondere für die Aufkörpermontage. Die Grundplatte 3 des Basisteils 2 ist umfänglich von dem Abdeckelement 22 umschlossen. Die in Figur 8 dargestellte Außenseite der Grundplatte 3 des Basisteils 2 mit den Senken 24 stellt die Betätigungsseite des kapazitiven Schalters 25 dar, wobei an den Stellen der Senken 24 das durch die LEDs 11 emittierte Licht aus der Grundplatte 3 des Basisteils 2 austreten kann. In der beschriebenen Ausführungsform umschließt das Abdeckelement 22 die Grundplatte 3 bündig und bildet mit ihr eine ebene Fläche. Dadurch ist einer Verschmutzung des kapazitiven Schalters 25 sehr gut vorgebeugt.

In Figur 9 ist eine Schnittdarstellung der ersten Ausführungsform eines kapazitiven Schalters 25 dargestellt. Die in Figur 9 dargestellte Ansicht ist in der Darstellung des kapazitiven Schalters 25 in Figur 8 durch die Darstellung des Schnitts A-A' sowie der Blickrichtung auf den Schnitt angegeben.. Die Außenfläche der Grundplatte 3 des Basisteils 2 weist Senken 24 auf, denen Erhebungen 4 auf der Innenseite zugeordnet sind. Die Erhebungen 4 erstrecken sich durch die Aussparungen in dem Dekorationselement 7 und in der Platine 9 bis hin zu den LEDs 11.

Der Niederdruck-Niedertemperatur-Verspritzwerkstoff 21 ist in dem Basisteil 2 zur Fixierung von Platine 9 und Dekorationselement 7 in dem Basisteil 2, und weiterhin an der Montageseite des Abdeckelementes 13 angeordnet. Um eine möglichst hohe Stabilität zu gewährleisten, erstreckt sich der Verspritzwerkstoff 21 auch umfänglich axial an dem Montageelement 13, wodurch ein Loslösen des Verspritzwerkstoffes 21 von dem Montageelement 13 verhindert ist. Das Abdeckelement 22 ist mit dem Montageelement 13 fixiert, indem die Rastelemente 23 mit dem Fixierflansch 16 verrastet sind. Das Basisteil 2 ist bei einer Montage des kapazitiven Schalters 25 an einem externen Körper zusätzlich dadurch fixiert, dass der Haltekragen 17 über den Halteflansch 6 einen Druck auf das Basisteil 2 in Richtung zum externen Körper ausübt.

Das Kabel 12 tritt im Wesentlichen senkrecht aus der Montageebene des kapazitiven Schalters 25 heraus, so dass es in oder hinter dem externen Körper, auf den der kapazitive Schalter 25 montiert wird, elektrisch kontaktiert werden kann. Der kapazitive Schalter 25 stellt eine ebene Fläche bereit, da Abdeckelement 22 und die Außenseite der Grundplatte 3 eine ebene Fläche bilden. Die ebene Fläche weist jedoch Senken 24 auf. In dem Schnitt gemäß Figur 9 sind die Montagedurchlässe 15 entsprechend der in Figur 8 eingezeichneten Blickrichtung auf den Schnitt mit unterschiedlicher Breite dargestellt. Die LEDs 11 sowie die Senken 24 und die Erhebungen 4, die nicht in der Schnittebene, sondern dahinter liegen, sind in Figur 9 gestrichelt dargestellt. Dabei sind an diesen LEDs 11 auch die seitlich angeordneten elektronischen Kontakte dargestellt.

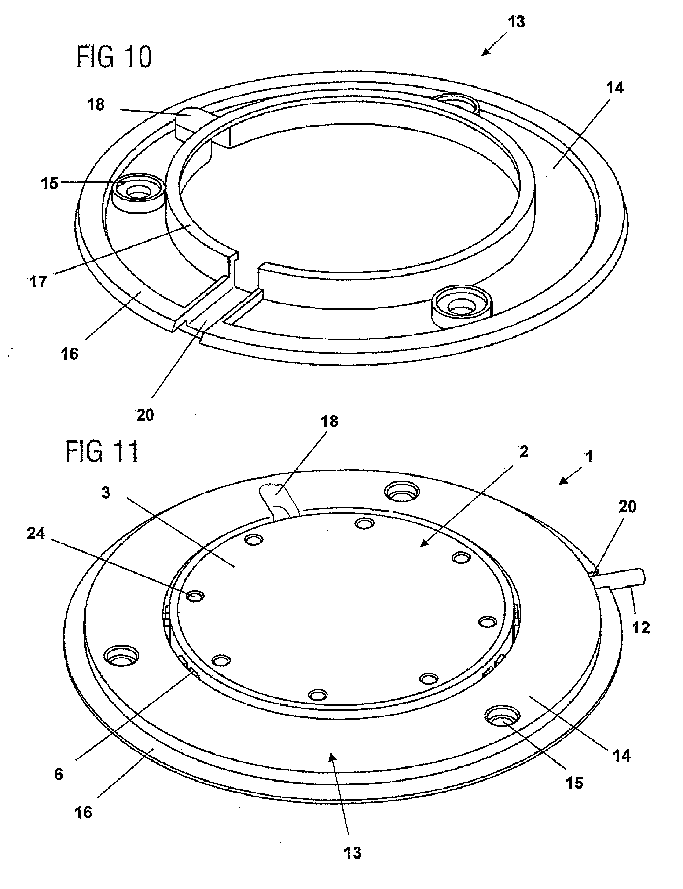

In Figur 10 ist eine weitere Ausführungsform eines von einem erfindungsgemäßen Grundkörper 1 umfassten Montageelementes 13 gezeigt. Dabei ist die der Montageseite abgewandte Seite des Montageelementes 13 dargestellt. Im Vergleich zu dem in Figur 4 abgebildeten Montageelement 13 weist das in Figur 10 dargestellte Montageelement 13 zusätzlich eine Aussparung 20 auf, die sich radial von der Innenmantelfläche 19 bis zum Umfang des Montagebereichs 14 erstreckt. Dadurch kann ein Kabel 12, das radial innerhalb des Montageelementes 13 angeordnet ist, auch seitlich aus dem Montageelement 13 herausgeführt werden, wobei es nicht über die durch den Rinnenabschnitt 18 dargestellte Durchführung senkrecht aus der Monatageseite austritt. Das in Figur 10 dargestellte Montageelement 13 kann beispielsweise durch ein Spritzgussverfahren hergestellt werden, wobei für das Spritzgussverfahren dasselbe Werkzeug verwendet werden kann, das auch für die Herstellung eines in Figur 4 abgebildeten Montageelementes 13 mittels Spritzgussverfahren verwendbar ist. Hierzu kann es genügen, in das für die Herstellung des Montageelementes 13 aus Figur 4 verwendete Werkzeug ein weiteres Werkzeugelement einzufügen um die Aussparung 20 in dem Montageelement 13 zu formen. In einer nicht dargestellten Ausführungsform kann das Montageelement 13 auch ausschließlich eine Aussparung 20 für die Durchführung eines Kabels 12, und keinen Rinnenabschnitt 18 aufweisen. Die Aussparung 20 muss dabei nicht zwingend den Haltekragen 17 unterbrechen.

In Figur 10 wird die zylinderartige Ausgestaltung der Montagedurchlässe 15 der beschriebenen Ausführungsform deutlich. Durch die zylinderartige Gestaltung, bei der innerhalb des Zylinders eine Auflagefläche für einen Schraubenkopf vorgesehen ist, kann eine hohe Stabilität bei der Montage des Montageelementes an einem externen Körper mittels Schrauben gewährleistet sein.

In Figur 11 ist ein erfindungsgemäßer Grundkörper 1 mit Sicht auf die Montageseite perspektivisch dargestellt. Der Grundkörper 1 umfasst ein Montageelement 13 nach Figur 10. Das Basisteil 2 ist radial innerhalb des Montageelementes 13 angeordnet. Das Kabel 12 tritt durch die Aussparung 20 des Montageelementes 13 seitlich aus diesem aus. Die Außenseite der Grundplatte 3 des Basisteils 2 liegt mit der Oberfläche des Montagebereichs 14 des Abdeckelementes 22 in einer Ebene. Bei der Montage des Grundkörpers 1 aus Figur 11 liegen somit die Montageseite des Montagebereichs 14 und die Grundplatte 3 zumindest abschnittsweise flächig an der Oberfläche des externen Körpers an, an dem der Grundkörper 1 montiert ist.

In einer nicht dargestellten Ausführungsform ragt die Grundplatte 3 axial über den Montagebereich 14 an der Montageseite heraus. Dadurch ist es beispielsweise möglich, auf den Montagebereich 14 ein Dekorelement oder Klebeelement aufzubringen, dessen Oberfläche dann mit der Außenseite der Grundplatte 3 in einer Ebene liegt und bei der Montage an einen externen Körper gemeinsam mit der Außenseite der Grundplatte 3 zumindest abschnittsweise an dem externen Körper flächig anliegen kann.

Der Halteflansch 6 des in Figur 11 abgebildeten Grundkörpers 1 ist in Form von Noppen ausgestaltet, die paarweise angeordnet sind. Die Noppenpaare können zueinander umfänglich und/oder axial beabstandet sein, so dass ein entsprechendes Zusammenwirken zwischen Haltekragen 17 und Halteflansch 6 ermöglicht ist, so dass zumindest eine der beiden Montageanordnungen Aufkörper- oder Hinterkörpermontage so realisierbar ist, dass das Basisteil 2 in dem Montageelement 13 in einem an einem externen Körper montierten Zustand des Grundkörpers 1 fixiert ist.

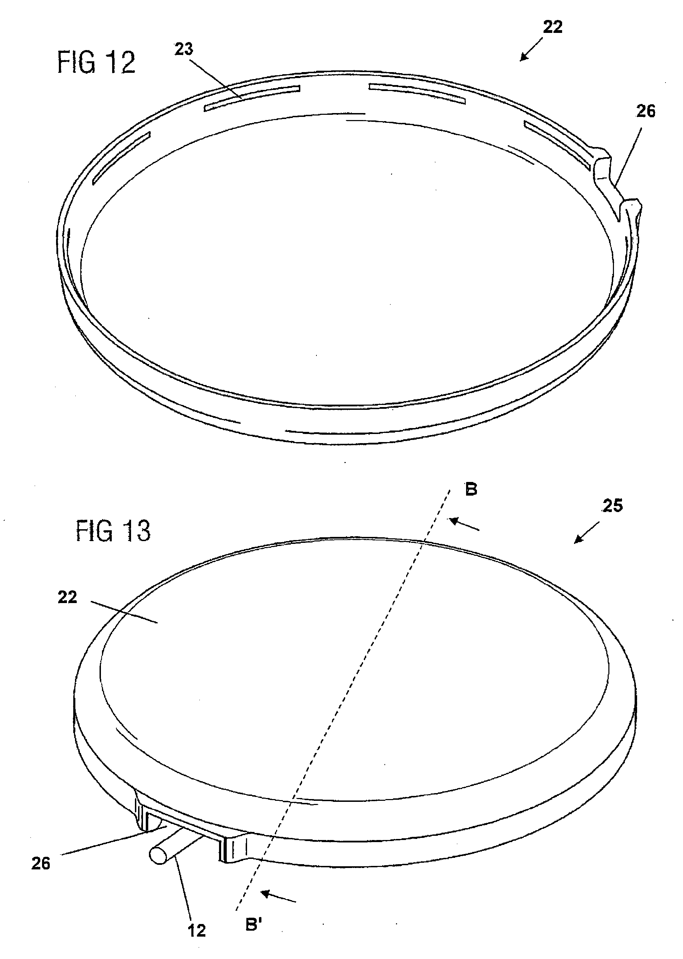

In Figur 12 ist ein Abdeckelement 22 einer zweiten erfindungsgemäßen Ausführungsform eines kapazitiven Schalters 25 perspektivisch dargestellt. Das in Figur 12 dargestellte Abdeckelement 22 ist entsprechend dem in Figur 7 dargestellten Abdeckelement 22 topfartig ausgebildet und weist analog an seinem Innenmantelbereich radial nach innen vorspringende Rastelemente 23 auf. Allerdings ist das in Figur 12 abgebildete Abdeckelement 22 mit geschlossenem Topfboden ausgebildet und weist keine Öffnung wie das in Figur 7 abgebildete Abdeckelement 22 auf. Zudem weist das in Figur 12 abgebildete Abdeckelement 22 eine Aussparung 26 auf, durch die ein Kabel 12 aus dem Innenraum des Abdeckelementes 22 seitlich nach außen geführt werden kann.

In Figur 13 ist die zweite Ausführungsform eines erfindungsgemäßen kapazitiven Schalters 25 perspektivisch dargestellt. Dabei ist die Sicht auf die der Montageseite abgewandte Seite des kapazitiven Schalters 25 gezeigt. Das Abdeckelement 22 umschließt den Grundkörper 1 des kapazitiven Schalters 25 an dem der Montageseite abgewandten Ende des Schalters mit Ausnahme des Bereichs der Aussparung 26 vollständig. Aus der Aussparung 26 in dem Abdeckelement 22 tritt seitlich das Kabel 12 aus dem kapazitiven Schalter 25 heraus. In der Aussparung 26 kann in einer nicht dargestellten Ausführungsform ein Material vorgesehen sein, das zumindest abschnittsweise an der Umwandung der Aussparung 26 und dem Kabel 12 anliegt, um eine Beschädigung in dem kapazitiven Schalter 25 bei Zugbelastung des Kabels 12 zu verhindern. Das Material kann beispielsweise durch Verkleben oder Vergießen zwischen Kabel 12 und Umwandung eingebracht sein. Der in Figur 13 abgebildete kapazitive Schalter 25 wird von der Montageseite aus, an der auch die Außenfläche der Grundplatte 3 des Basisteils 2 liegt, betätigt. In der dargestellten Ausführungsform dient das Abdeckelement 22 dem Schutz der Schaltungselektronik in dem Schalter 25 und stellt den der Montageseite abgewandten optischen Abschluss des kapazitiven Schalters 25 dar.

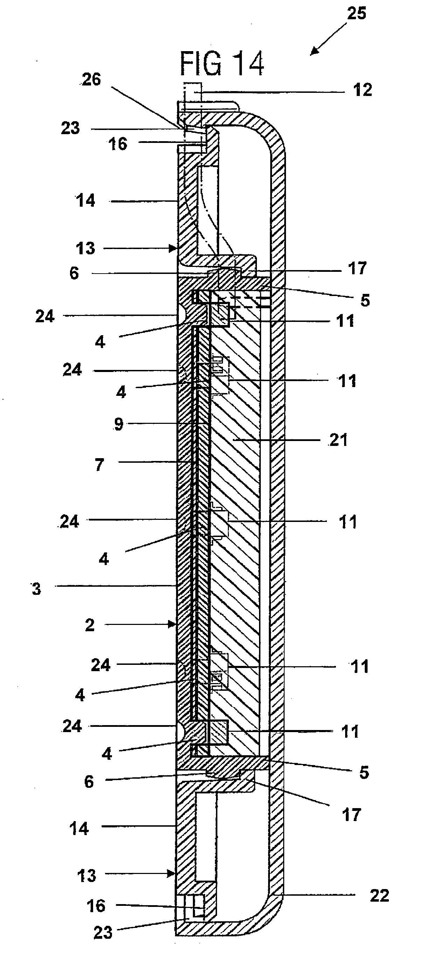

In Figur 14 ist eine Schnittdarstellung der in Figur 13 abgebildeten zweiten Ausführungsform eines erfindungsgemäßen kapazitiven Schalters 25 dargestellt. Der Verlauf des Schnitts B-B' und die Blickrichtung auf den Schnitt, der in Figur 14 dargestellt ist, ist in Figur 13 angegeben.

Die LEDs 11, Senken 24 und Erhebungen 4, die nicht in der Schnittebene liegen, sondern hinter der Schnittebene in dem Niederdruck-Niedertemperatur-Verspritzwerkstoff 21, sind in Figur 14 gestrichelt dargestellt. Die Aussparung in der Umwandung 5 des Basisteils 2, die nicht in der Schnittebene sondern in einem gekrümmten Bereich hinter der Schnittebene liegt, ist durch eine unterbrochene Linie dargestellt. Der Einfachheit halber ist in Figur 14 die Aussparung 20 in dem Montageelement 13 nicht dargestellt. Der Verlauf des Kabels 12 ist in Figur 14 jedoch in einer strichpunktierten Form schematisch dargestellt.

Die Außenseite der Grundplatte 3 des Basisteils 2 liegt mit der Oberfläche des Montagebereichs 14 des Abdeckelementes 13 in einer Ebene und liegt in dem an einem externen Körper montierten Zustand des kapazitiven Schalters 25 an dem externen Körper zumindest abschnittsweise flächig an. Dabei steht der Halteflansch 6 der in Form von Noppen ausgebildet ist, in Kontakt mit dem Haltekragen 17, so dass bei einer Fixierung des Montageelementes 13 an einem externen Körper das Basisteil 2 fest fixiert an dem externen Körper anliegt. In der dargestellten Ausführungsform liegt der Halteflansch 6 zudem seitlich an der Innenmantelfläche 19 des Montageelementes 13 an, wodurch die Fixierung des Basisteils 2 in dem Montageelement noch verbessert ist.

Der kapazitive Schalter 25 kann beispielsweise von der Innenseite des externen Körpers aus oder, bei einem dünnen externen Körper, von der dem Schalter 25 abgewandten Seite des externen Körpers aus bedienbar sein. In einer nicht dargestellten Ausführungsform kann die Oberfläche der Außenseite der Grundplatte 3 auch über die Oberfläche des Montagebereichs 14 herausragen oder die Oberfläche des Montagebereichs 14 über die Außenseite der Grundplatte 3 herausragen, so dass weitere Bauteile zwischen der Montageseite des kapazitiven Schalters 25 und dem externen Körper vor der Montage des Schalters 25 an den externen Körper angeordnet werden können und gleichzeitig ein Anpressdruck auf das Basisteil 2 in Richtung zum externen Körper durch das Zusammenwirken von Halteflansch 6 und Haltekragen 17 gewährleistet ist.

Aus der Schnittdarstellung in Figur 14 wird deutlich, dass in der dargestellten Ausführungsform das Abdeckelement 22 den Grundkörper 1 bis auf die Montageseite im Wesentlichen vollständig umschließt. Das Kabel 12 kann durch die Aussparung 26 in dem Abdeckelement 22 seitlich von dem kapazitiven Schalter 25 weggeführt werden. Die Fixierung des Abdeckelementes 22 an dem Grundkörper 1 bzw. an dem Montageelement 13 ist durch das Zusammenwirken von Rastelementen 23 und dem Fixierflansch 16 gewährleistet.

Aus Figur 14 geht ferner hervor, dass der Fixierflansch umfänglich angeschrägt ist, und dass die radiale Erstreckung der Rastelemente 23 von dem Innenmantelbereich des Abdeckelementes 22 axial in Richtung zur Montageseite abnimmt. Dadurch kann das Abdeckelement 22 sehr leicht auf das Montageelement 13 aufgeschoben werden und nur schwer von dem Montageelement 13 entfernt werden, so dass ein besonders guter Schutz des kapazitiven Schalters 25 vor Vandalismus gewährleistet ist. In dem Basisteil 2 ist die Platine 9 durch einen Verspritzwerkstoff fixiert. Die Platine 9 und das Dekorationselement 7 sind durch das Zusammenwirken von den Aussparungen 8, 10 mit Erhebungen 4 in dem Basisteil 2 ausgerichtet und fixiert. Dekorationselement 7 und Platine 9 erstrecken sich flächig und radial bis zur Umwandung 5 des Basisteils 2, so dass bei dem Verspritzprozess ein Eindringen des Verspritzwerkstoffes 21 zwischen Platine 9 und Dekorationselement 7 bzw. zwischen Dekorationselement 7 und Grundplatte 3 wirksam verhindert ist.

Ein kapazitiver Schalter 25 wie in den Figuren 13 und 14 dargestellt eignet sich beispielsweise für eine Hinterglasmontage. Dabei kann als externer Körper eine Glasscheibe verwendet werden, durch die die Außenseite der Grundplatte 3 sichtbar ist, und über die eine Betätigung des kapazitiven Schalters möglicht ist. Bei einer solchen Montage kann vorzugsweise ein dekoratives Klebemittel vorgesehen sein, das ringartig ausgestaltet ist, auf dem Montagebereich 14 befestigt ist und das sich radial von dem Umfang des Basisteils 2 bis zum Umfang des Abdeckelements 22 hin erstreckt. Dadurch kann eine Fixierung und gleichzeitig ein ansprechendes und optisches Design des kapazitiven Schalters 25 gewährleistet sein, wenn dieser von der der Montageseite abgewandten Seite der Glasscheibe betrachtet wird.

Ein solcher mittels Hinterglasmontage befestigter kapazitiver Schalter kann beispielsweise in öffentlichen Bussen und Bahnen als Türöffnungsschalter Anwendung finden. Dabei kann der Schalter in dem Bus- bzw. Bahninnenraum montiert sein und von außen durch die Glasscheibe sichtbar und betätigbar sein.

Ein mittels Aufkörpermontage befestigter kapazitiver Schalter kann ebenfalls in Bussen und Bahnen Anwendung finden, beispielsweise als Haltewunschtaster oder Türöffnungsschalter vom Innenraum aus. Auch kann ein solcher Schalter an Maschinen, wie etwa Zerkleinerungsmaschinen, Förderbändern oder Werkzeugmaschinen, für die Betätigung der Maschinen eingesetzt werden.

### Bezugszeichenliste

- 1: Grundkörper
- 2: Basisteil
- 3: Grundplatte
- 4: Erhebung
- 5: Umwandung
- 6: Halteflansch
- 7: Dekorationselement
- 8: Aussparung im Dekorationselement
- 9: Platine
- 10: Aussparung in der Platine
- 11: LED
- 12: Kabel
- 13: Montageelement
- 14: Montagebereich
- 15: Montagedurchlass
- 16: Fixierflansch
- 17: Haltekragen
- 18: Rinnenabschnitt
- 19: Innenmantelfläche
- 20: Aussparung im Montageelement
- 21: Niederdruck-Niedertemperatur-Verspritzwerkstoff
- 22: Abdeckelement
- 23: Rastelement
- 24: Senke
- 25: kapazitiver Schalter
- 26: Aussparung im Abdeckelement

## Patentansprüche

1. Grundkörper (1) für einen kapazitiven Schalter (25) mit flacher Betätigungsfläche zum Auslösen des Schalters, wobei der Grundkörper (1) ein Basisteil (2) umfasst, das zumindest abschnittsweise transparent ist und eine Grundplatte (3) mit Innen- und Außenseite sowie eine Umwandung (5) umfasst, wobei die Umwandung (5) umfänglich an der Innenseite der Grundplatte (3) angeordnet ist und sich axial zu ihr erstreckt, und wobei das Basisteil (2) so ausgebildet ist, dass von der Außenseite der Grundplatte (3) aus eine Schaltungselektronik betätigbar ist, wobei auf der Innenseite der Grundplatte (3) eine Platine (9) mit der Schaltungselektronik angeordnet ist, wobei die Grundplatte (3) an ihrer Innenseite zusätzlich zumindest eine axiale Erhebung (4) aufweist, und die Platine (9) Aussparungen (10) aufweist, wobei die Erhebungen (4) der Grundplatte (3) in den Aussparungen (10) der Platine (9) angeordnet sind.

2. Grundkörper (1) nach Anspruch 1, **dadurch gekennzeichnet, dass** auf der der Innenseite der Grundplatte (3) des Basisteils (2) abgewandten Seite der Platine (9) zumindest eine LED (11) angeordnet ist, die mit zumindest einer Aussparung (10) fluchtet, wobei die Aussparung (10) als durchgängiges Loch in der Platine (9) ausgebildet ist.

3. Grundkörper (1) nach einem der vorangehenden Ansprüche, **dadurch gekennzeichnet, dass** zwischen der Innenseite der Grundplatte (3) des Basisteils (2) und der Platine (9) ein scheibenförmiges Dekorationselement (7) angeordnet ist.

4. Grundkörper (1) nach einem der vorangehenden Ansprüche, **dadurch gekennzeichnet, dass** die Platine (9) in dem Basisteil (2) mit einem Niederdruck-Niedertemperatur-Verspritzwerkstoff (21) fixiert ist.

5. Grundkörper (1) nach einem der vorangehenden Ansprüche, **dadurch gekennzeichnet, dass** der Grundkörper (1) ein Montageelement (13) umfasst, in dem das Basisteil (2) angeordnet ist, wobei das Montageelement (13) eine Montageseite aufweist zum Anlegen an einen externen Körper für eine Montage an dem Körper, wobei das Basisteil (2) zumindest abschnittsweise radial innerhalb des Montageelements (13) angeordnet und gehaltert ist, wobei das Montageelement (13) einen sich radial erstreckenden Montagebereich (14) umfasst, dessen eines axiales Ende an der Montageseite liegt.

6. Grundkörper (1) nach Anspruch 5, **dadurch gekennzeichnet, dass** Basisteil (2) und Montageelement (13) integral hergestellt sind.

7. Grundkörper (1) nach Anspruch 5, **dadurch gekennzeichnet, dass** das Montageelement (13) einen im Wesentlichen ringförmigen Bereich mit einer Innenmantelfläche (19) aufweist, radial innerhalb dessen das Basisteil (2) angeordnet ist, wobei das Basisteil (2) zumindest ein umfänglich außen angeordnetes erstes Halteelement (6) aufweist, und wobei das Montageelement (13) zumindest ein zweites Halteelement (17) an der Innenmantelfläche (19) des Montageelementes (13) aufweist, das mit dem zumindest einen ersten Halteelement (17) korrespondiert.

8. Grundkörper (1) nach Anspruch 7, **dadurch ge**- **kennzeichnet**, **dass** Basisteil (2) und Montageelement (13) so ausgestaltet sind, dass das Basisteil (2) in dem Montageelement (13) sowohl so anordenbar ist, dass die Außenseite der Grundplatte (3) zu der Montageseite weist, als auch so, dass die Außenseite der Grundplatte (3) von der Montageseite weg weist, wobei Basisteil (2) und Montageelement (13) zumindest in dem an dem externen Körper montierten Zustand zueinander fixiert sind.

9. Grundkörper (1) nach einem der Ansprüche 7 oder 8, **da**- **durch gekennzeichnet**, **dass** das erste Halteelement (13) des Basisteils (2) als umfänglich verlaufender Halteflansch (6) ausgebildet ist.

10. Grundkörper (1) nach Anspruch 9, **dadurch ge**- **kennzeichnet, dass** der Halteflansch (6) des Basisteils (2) so angeordnet ist, dass der axiale Abstand von der Außenseite der Grundplatte (3) des Basisteils (2) zu dem Halteflansch (6) im Wesentlichen identisch mit dem axialen Abstand von dem der Außenseite gegenüberliegenden axialen Ende des Basisteils (2) zu dem Halteflansch (6) ist.

11. Grundkörper (1) nach einem der Ansprüche 9 oder 10,
**dadurch gekennzeichnet, dass** das zweite Halteelement (17) des Montageelementes (13) einen an der Innenmantelfläche (19) des Montageelementes (13) umfänglich verlaufenden Vorsprung (17) umfasst, der sich radial von der Innenmantelfläche (19) in Richtung zum Zentrum des ringförmigen Bereichs erstreckt, an dem der Halteflansch (6) des Basisteils (2) im montierten Zustand der Montageanordnung zumindest abschnittsweise anliegt.

12. Grundkörper (1) nach Anspruch 11, **dadurch gekennzeichnet, dass** ein axiales Ende des Basisteils (2) an der Montageseite des Montageelementes (13) liegt, und dass die axiale Erstreckung des Montageelementes (13) von der Montageseite zu der Kontaktfläche zwischen Halteflansch (6) und Vorsprung (17) der axialen Erstreckung des Basisteils von der Montageseite zu der Kontaktfläche zwischen Halteflansch und Vorsprung (17) entspricht.

13. Grundkörper nach einem der Ansprüche 5 bis 11, **dadurch gekennzeichnet, dass** mittels eines Niederdruck-Niedertemperatur-Verspritzwerkstoffs (21) eine stoffschlüssige Verbindung zwischen dem Montageelement (13) und dem Basisteil (2) hergestellt ist.

14. Grundkörper (1) nach einem der Ansprüche 5 bis 13, **dadurch gekennzeichnet, dass** das Montageelement (13) zur Kabeldurchführung innerhalb seines Montagebereichs (14) einen zur Montageseite offenen Rinnenabschnitt (18) aufweist, der sich radial von der Innenmantelfläche (19) des Montageelementes (13) zum Umfang hin erstreckt, wobei der Rinnenabschnitt (18) an seiner der Innenmantelfläche (19) zugewandten Seite offen und an seiner dem Umfang des Montageelementes (13) zugewandten Seite geschlossen ist.

15. Kapazitiver Schalter (25) umfassend einen Grundkörper (1) nach einem der Ansprüche 1 bis 14, **dadurch gekennzeichnet, dass** der Schalter ein Abdeckelement (22) umfasst, wobei das Montageelement (13) innerhalb des Abdeckelements (22) angeordnet und das Abdeckelement (22) an dem Montageelement (13) befestigt ist, wobei das Abdeckelement (22) einen hohlzylinderförmigen Bereich aufweist, der sich von der Montageseite aus axial über das Montageelement (13) erstreckt und an dem der Montageseite gegenüberliegenden Ende zumindest abschnittsweise geschlossen ist, wobei das Montageelement (13) radial innerhalb des hohlzylinderförmigen Bereichs in dem Abdeckelement (22) befestigt ist und zumindest abschnittsweise an seinem der Montageseite abgewandten Ende von dem Abdeckelement (22) bedeckt ist.

16. Kapazitiver Schalter (25) nach Anspruch 15, **dadurch gekennzeichnet, dass** das Abdeckelement (22) das Montageelement (13) und das Basisteil (2) umfänglich und an dem der Montageseite gegenüberliegenden axialen Ende im Wesentlichen vollständig flächig umschließt, wobei die Außenseite der Grundplatte (3) des Basisteils (2) an der Montageseite liegt.

17. Kapazitiver Schalter (25) nach Anspruch 15, **dadurch gekennzeichnet, dass** das Abdeckelement (22) das Montageelement (13) und das Basisteil (2) umfänglich und das Montageelement (13) an dem der Montageseite gegenüberliegenden axialen Ende im Wesentlichen vollständig umschließt, und dass das Abdeckelement (22) die Grundplatte (3) des Basisteils (2) umfänglich umschließt, wobei die Außenseite der Grundplatte (3) des Basisteils (2) an dem der Montageseite gegenüberliegenden axialen Ende des Schalters (25) liegt.

18. Kapazitiver Schalter (25) nach einem der Ansprüche 15 bis 17, **dadurch gekennzeichnet, dass** das Montageelement (13) einen Fixierflansch (16) und das Abdeckelement (22) an der Innenfläche des hohlzylinderförmigen Bereichs Rastelemente (23) aufweist, wobei Fixierflansch (16) und Rastelemente (23) zur Fixierung des Montageelementes (13) innerhalb des Abdeckelementes (22) miteinander korrespondieren.

## Claims

1. Basic body (1) for a capacitive switch (25) with a flat actuating surface for releasing the switch, wherein the base body (1) comprises a base part (2) which is transparent at least in section thereof and has a base plate (3) comprising an inner and outer side as well as a peripheral wall (5), wherein the peripheral wall (5) is circumferentially disposed on the inside of the base plate (3) and extends axially to it, and wherein the base part (2) is designed so that from the outside of the base plate (3) an electronic circuitry can be operated, wherein on the inside of the base plate (3) a circuit board (9) carrying the electronic circuitry is arranged, wherein the base plate (3) additionally has on the inside thereof at least one axial elevation (4) and the circuit board (9) includes recesses (10), wherein the elevations (4) on the base plate (3) are disposed in the recesses (10) of the circuit board (9).

2. Basic body (1) according to claim 1, **characterized in that** on the side of the circuit board (9) facing away from inside of the base plate (3) of the base part (2) at least one LED (11) is arranged that is aligned with at least one recess (10), wherein the recess is formed (10) as a through hole in the circuit board (9).

3. Basic body (1) according to one of the preceding claims, **characterized in that** between the inside of the base plate (3) of the base part (2) and the circuit board (9) a disc-shaped decorative element (7) is arranged.

4. Basic body (1) according to one of the preceding claims, **characterized in that** the plate (9) is fixed in the base part (2) by means of low pressure-low temperature extrusion material (21).

5. Basic body (1) according to one of the preceding claims, **characterized in that** the base body (1) comprises a mounting element (13) in which the base part is disposed (2), wherein the mounting element (13) has a mounting side for being applied against an external body for mounting to the body, wherein at least a section of the base part (2) is disposed and held radially inward of the mounting element (13), wherein the mounting element (13) has a radially extending mounting portion (14) whose axial end is located on the mounting side.

6. Basic body (1) according to claim 5, **characterized in that** the base part (2) and the mounting element (13) are integrally manufactured.

7. Basic body (1) according to claim 5, **characterized in that** the mounting element (13) has a substantially annular portion with an inner lateral surface area (19) that is arranged radially inwards of the base part (2), wherein the base part (2) comprises at least one circumferentially outwardly disposed first holding element (6), and wherein the mounting element (13) comprises at least a second holding element (17) on the inner lateral surface area (19) of the mounting element (13) which corresponds with said at least one first holding element (17).

8. Basic body (1) according to claim 7, **characterized in that** the base part (2) and the mounting element (13) are so designed that the base part (2) can be disposed in the mounting element (13) both in such a manner that the outer side of the base plate (3) points to the mounting side and that the outside of the base plate (3) points away from the mounting side, wherein the base part (2) and the mounting element (13) are fixed to each other at least in the condition mounted to the external body.

9. Basic body (1) according to one of the claims 7 or 8, **characterized in that** the first holding element (13) of the base part (2) is configured as a circumferentially extending holding flange (6).

10. Basic body (1) according to claim 9, **characterized in that** the holding flange (6) of the base part (2) is arranged in such a way that the axial distance from the outside of the base plate (3) of the base part (2) to the holding flange (6) is substantially identical to the axial distance from the outside of the opposing axial end of the base portion (2) to the holding flange (6).

11. Basic body (1) according to one of claims 9 or 10, **characterized in that** the second holding element (17) of the mounting element (13) comprises a protrusion (17) circumferentially extending on an inner lateral area (19) of the mounting element (13), said protrusion (17) extending radially from the inner lateral area (19) towards the center of the annular portion against which the flange (6) of the base part (2) is applied at least in sections in the assembled state of the mounting structure.

12. Basic body (1) according to claim 11, **characterized in that** an axial end of the base part (2) is located on the mounting side of the mounting element (13) and that the axial dimension of the mounting element (13) from the mounting side to the contact surface between the holding flange (6) and the protrusion (17) corresponds to the axial dimension of the base part from the mounting side to the contact surface between the holding flange and the protrusion (17).

13. Basic body according to one of the claims 5 to 11, **characterized in that** a substance-to-substance connection between the mounting element (13) and the base part (2) is produced by means of a low pressure-low temperature extrusion material (21).

14. Basic body (1) according to one of claims 5 to 13, **characterized in that** for the feed-through of cables, the mounting element (13) within its mounting section (14) includes a trough section (18) which is open to the mounting side and which radially extends from the inner lateral area (19) of the mounting element (13) towards the periphery, wherein the trough section (18) is open on its side facing towards the inner lateral area (19) and is closed on its side facing towards the periphery of the mounting element (13).

15. Capacitive switch (25) comprising a basic body (1) according to any one of claims 1 to 14, **characterized in that** the switch comprises a cover element (22), wherein the mounting element (13) is disposed within the cover element (22) and the cover element (22) is fixed to the mounting element (13), wherein the cover element (22) has a hollow cylindrical portion extending from the mounting side axially over the mounting element (13) and is closed on the end opposite to the mounting side at least in section, wherein the mounting element (13) is fixed radially inwardly of the hollow cylindrical portion in the cover element (22) and is covered on its end facing away from the mounting side by the cover element (22) at least in section.

16. Capacitive switch (25) according to claim 15, **characterized in that** the cover element (22) covers the mounting element (13) and the base part (2) circumferentially as well as substantially laminarly on the axial end opposite the mounting side, wherein the outside of the base plate (3) of the base part (2) is located on the mounting side.

17. Capacitive switch (25) according to claim 15, **characterized in that** the cover element (22) surrounds the mounting element (13) and the base part (2) circumferentially and the mounting element (13) substantially fully on the axial end opposite the mounting side, and that the cover element (22) surrounds the base plate (3) and the base part (2) circumferentially, wherein the outside of the base plate (3) of the base part (2) is positioned on the axial end of the switch (25) opposite the mounting side.

18. Capacitive switch (25) according to one of the claims 15 to 17, **characterized in that** the mounting element (13) includes a fixing flange (16) and the cover element (22) includes locking elements (23) on the inner surface of the hollow cylindrical portion, said fixing flange (16) and locking elements (23) mating each other for fixing the mounting element (13) within the cover member (22).

## Revendications

1. Corps de base (1) pour commutateur capacitif (25) comprenant une surface de commande pour le déclenchement du commutateur, le corps de base (1) comprenant une pièce de base (2) au moins partiellement transparent et une plaque de base (3) avec une face interne et une face externe ainsi qu'une paroi périphérique (5), ladite paroi périphérique étant disposée de manière circonférentielle sur la face interne de la plaque de base (3) et s'étendant axialement par rapport à celle-ci, et la pièce de base (2) étant configurée d'une manière telle qu'un circuit électronique peut être commandé de la face externe de la plaque de base (3), sur ladite face interne de la plaque de base (3) étant disposée une platine (9) portant ledit circuit électronique, la plaque de base (3) comportant en outre, sur sa face interne, au moins un renflement axial (4), et la platine (9) comportant des évidements (10) dans lesquels sont disposés lesdits renflements (4) de la plaque de base (3).

2. Corps de base (1) selon la revendication 1, **caractérisé en ce que** sur le côté de la platine (9) détourné de la face interne de la plaque de base (3) est arrangé au moins une diode lumineuse (11) alignée avec au moins un évidement (10), ledit évidement étant configuré comme une ouverture de passage dans la platine (9).

3. Corps de base (1) selon l'une quelconque des revendications précédentes, **caractérisé en ce qu'**entre la face interne de la plaque de base (3) de la pièce de base (2) et la platine (9) est arrangé un élément de décoration en forme de disque (7).

4. Corps de base (1) selon l'une quelconque des revendications précédentes, **caractérisé en ce que** la platine (9) est fixée dans la pièce de base (3) par un matériau de moulage par l'injection à pression et à température basses (21).

5. Corps de base (1) selon l'une quelconque des revendications précédentes, **caractérisé en ce que** le corps de base (1) comporte un élément de montage (13), dans lequel est disposée la pièce de base (2), l'élément de montage (13) présentant une face de montage pour être appliquée contre un corps externe pour le montage sur le corps, la pièce de base (2) étant au moins partiellement disposée et supportée radialement dans l'élément de montage (13), l'élément de montage (13) comprenant une zone de montage (14) s'étendant radialement, l'une de ses extrémités axiales se situant sur le côté de montage.

6. Corps de base (1) selon la revendication 5, **caractérisé en ce que** la pièce de base (2) et l'élément de montage (13) sont fabriqués intégralement.

7. Corps de base (1) selon la revendication 5, **caractérisé en ce que** l'élément de montage (13) présente une zone essentiellement annulaire avec une face latérale interne (19), dans laquelle est disposée radialement la pièce de base (2), la pièce de base (2) comportant sur sa circonférence extérieure au moins un premier élément de support (6), et l'élément de montage (13) comportant au moins un deuxième élément de support (17) sur la face latérale interne (19) de l'élément de montage (13) qui correspond avec l'au moins un premier élément de support (17).

8. Corps de base (1) selon la revendication 7, **caractérisé en ce que** la pièce de base (2) et l'élément de montage (13) sont configurés de sorte que la pièce de base (2) peut être disposée dans l'élément de montage (13) d'une manière telle que la face externe de la plaque des base (3) est tournée vers le côté de montage et aussi d'une manière telle que la face externe de la plaque de base (3) est détournée du côté de montage, la pièce de base (2) et l'élément de montage (13) étant fixés l'une par rapport à l'autre, au moins dans l'état monté au corps externe.

9. Corps de base (1) selon l'une quelconque des revendications 7 ou 8, **caractérisé en ce que** le premier élément de support (13) de la pièce de base (2) est en forme d'une bride de support (6) s'étendant de manière circonférentielle.

10. Corps de base (1) selon la revendication 9, **caractérisé en ce que** la bride de support (6) de la pièce de base (2) est disposée de sorte que la distance axiale de la face externe de la plaque de base (3) de la pièce de base (2) à la bride de support (6) est essentiellement identique avec la distance axiale de l'extrémité axiale de la pièce de base (2) en regard de la face externe à la bride de support (6).

11. Corps de base (1) selon l'une quelconque des revendications 9 ou 10, **caractérisé en ce que** le deuxième élément de support (17) de l'élément de montage (13) comporte un épaulement (17) s'étendant de manière circonférentielle sur la face latérale interne (19) de l'élément de montage (13) et s'étendant radialement de la face latérale interne (19) vers le centre de la zone annulaire contre laquelle s'applique la bride de support (6) de la pièce de base (2), au moins par passages, dans l'état monté de l'ensemble de montage.

12. Corps de base (1) selon la revendication 11, **caractérisé en ce qu'**une extrémité axiale de la pièce de base (2) se trouve sur le côté de montage de l'élément de montage (13) et **en ce que** la dimension axiale de l'élément de montage (13) du côté de montage à la surface de contact entre la bride de montage (6) et l'épaulement (17) correspond à la dimension axiale de la pièce de base (2) du côté de montage à la surface de contact entre la bride de support et l'épaulement (17).

13. Corps de base selon l'une des revendications 5 à 11, **caractérisé en ce qu'**une adhérence des matériaux entre l'élément de montage (13) et la pièce de base (2) est établie au moyen d'un matériau de moulage par l'injection à pression et à température basses (21).

14. Corps de base (1) selon l'une quelconque des revendications 5 à 13, **caractérisé en ce que**, pour le passage du câble, l'élément de montage (13) dans sa zone de montage (14) présente une partie de conduit ouverte (18) vers le côté de montage, partie qui s'étend radialement de la face latérale interne (19) de l'élément de montage (13) vers la circonférence, ladite partie de conduit (18) étant ouverte sur son côté tourné vers la circonférence de l'élément der montage (13) et étant fermée sur son côté tourné vers la circonférence de l'élément de montage (13).

15. Commutateur capacitif (25) comprenant un corps de base (1) selon l'une quelconque des revendications 1 à 14, **caractérisé en ce que** le commutateur présent un élément de recouvrement (22), l'élément de montage (13) étant disposé dans l'élément de recouvrement (22) et l'élément de recouvrement (22) étant fixé à l'élément de montage (13), l'élément de recouvrement (22) présentant une zone de forme de cylindre creux qui s'étend axialement du côté de montage à travers de l'élément de montage (13) et qui est fermée au moins partiellement, sur l'extrémité opposée au côté de montage, l'élément de montage (13) étant fixé radialement dans la zone en forme de cylindre creux à l'intérieur de l'élément de recouvrement (22) et étant recouvert au moins partiellement de l'élément de recouvrement (22) sur son extrémité détournée du côté de montage.

16. Commutateur capacitif (25) selon la revendication 15, **caractérisé en ce que** l'élément de recouvrement (22) environne de manière circonférentielle l'élément de montage (13) et la pièce de base (2) et les environne essentiellement sur toute la surface sur l'extrémité axiale opposée au côté de montage, la face externe de la plaque de base (3) de la pièce de base (2) étant située sur le côté de montage.

17. Commutateur capacitif (25) selon la revendication 15, **caractérisé en ce que** l'élément de recouvrement (22) environne de manière circonférentielle l'élément de montage (13) et la pièce de base (2) et complètement environne l'élément de montage sur l'extrémité axiale opposée au côté de montage et **en ce que** l'élément de recouvrement (22) environne de manière circonférentielle la plaque de base (3) et la pièce de base (2), la face externe de la plaque de base (3) de la pièce de base (2) se situant sur l'extrémité du commutateur (25) opposée au côté de montage.

18. Commutateur capacitif (25) selon l'une des revendications 15 à 17, **caractérisé en ce que** l'élément de montage (13) présente une bride de fixation (16) et l'élément de recouvrement (22) présente, sur la face interne de la partie en forme de cylindre creux, des éléments d'encliquetage (23), la bride de fixation (16) et les éléments d'encliquetage (23) correspondant l'une à l'autre pour la fixation de l'élément de montage (13) dans l'élément de recouvrement (22).
